(19) Europäisches Patentamt
European Patent Office
Office européen des brevets

(11) **EP 2 991 126 B1**

(12) **EUROPÄISCHE PATENTSCHRIFT**

(45) Veröffentlichungstag und Bekanntmachung des Hinweises auf die Patenterteilung:
**05.10.2016 Patentblatt 2016/40**

(51) Int Cl.:
*H01L 39/14* *(2006.01)*     *H01L 39/24* *(2006.01)*

(21) Anmeldenummer: **14182132.2**

(22) Anmeldetag: **25.08.2014**

(54) **Verfahren und Vorrichtung zum Herstellen eines Hochtemperatur-Supraleiters**

Method and device for producing a high temperature superconductor

Procédé et dispositif de fabrication d'un supraconducteur haute température

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**02.03.2016 Patentblatt 2016/09**

(73) Patentinhaber: **Theva Dünnschichttechnik GmbH 85737 Ismaning (DE)**

(72) Erfinder:
• **Prusseit, Werner 85737 Ismaning (DE)**

• **Grosse, Veit 85435 Erding (DE)**
• **Gemisic Adamov, Minja 85748 Garching (DE)**

(74) Vertreter: **Wegner, Hans Bardehle Pagenberg Partnerschaft mbB Patentanwälte, Rechtsanwälte Prinzregentenplatz 7 81675 München (DE)**

(56) Entgegenhaltungen:
**DE-B3-102013 210 940    JP-A- 2005 056 591 US-A- 5 948 172       US-A1- 2004 266 628 US-A1- 2007 111 893**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

**1.** Technisches Gebiet

Die vorliegende Erfindung betrifft ein Verfahren und eine Vorrichtung zum Herstellen eines Hochtemperatur-Supraleiters.

**2.** Stand der Technik

Hochtemperatur-Supraleiter stellen in der Elektro- und Energietechnik ein Standardleitermaterial dar, aus dem Leitungen, Kabel oder Windungen und Spulen hergestellt werden. HTS-Bandleiter ersetzen in diesen Anwendungen Kupferdraht, da sie um ein Vielfaches höhere elektrische Ströme transportieren können. Diese hohen Ströme würden im Kupfer zu hohen ohmschen Verlusten führen. Mit dem Einsatz von Supraleitern können diese Verluste verringert und eine erheblich kompaktere Bauweise realisiert werden.

Weiterhin können auch Komponenten, bei denen bereits heute metallische Supraleiter statt Kupferleiter eingesetzt werden, z.B. Magnetresonanztomographen oder starke Elektromagnete, verbessert werden. Hochtemperatur-Supraleiter erlauben eine deutlich höhere Betriebstemperatur und halten höheren Magnetfeldern stand. Zudem führt die resultierende Verringerung des Kühlaufwandes zu einem einfacheren Aufbau und einer Verbesserung des Wirkungsgrades.

Die Herstellung von HTS-Bandleitern erfolgt durch kontinuierliche, physikalische oder chemische Beschichtungsverfahren von Rolle zu Rolle. Ein flexibles, metallisches Substratband wird dabei von einer Vorratsrolle abgespult, durch Beschichtungs- und Prozesszonen geführt und auf der anderen Seite wieder auf eine Vorratsspule aufgewickelt.

Die Beschichtung mit Pufferschichten und HTS-Schichten erfolgt normalerweise einseitig, d.h. auf einer polierten oder geglätteten Hauptfläche des Substratbands. Die Pufferschichten stellen einzeln oder in ihrer Abfolge als Multilagen gute elektrische Isolatoren, bzw. schlechte elektrische Leiter dar, so dass ein direkter Stromfluss zwischen der HTS-Schicht und dem Metallsubstrat nicht möglich ist. Im Einsatz als elektrischer Leiter können sich also die HTS-Schicht und das Metallsubstrat lokal auf unterschiedlichem elektrischem Potenzial befinden. Da die Pufferschichten nur sehr dünn sind (im Bereich einiger Mikrometer), können bereits bei einigen Volt Potenzialdifferenz zwischen der HTS-Schicht und dem Metallsubstrat, elektrische Felder von einigen $10^6$ V/m über der oder den Pufferschicht(en) entstehen, so dass es zum dielektrischen Durchbruch kommen kann, der mit der lokalen Zerstörung der Schichten und damit des HTS-Bandleiters einhergeht.

Es ist deshalb zwingend erforderlich, einen separaten und möglichst niederohmigen elektrischen Kontakt zwischen der HTS-Schicht und dem Metallsubstrat herzustellen. Dies wurde insbesondere dort erkannt, wo der HTS-Bandleiter explizit zum Schalten zwischen dem supraleitenden und dem normalleitenden Zustand eingesetzt wird. So beschreibt die EP 1114 471 B1 Durchkontaktierungen auf der Substratvorderseite durch das Freilegen von Fenstern. Die EP 1042 820 B1 sieht eine fortlaufende Kontaktierung auf der Vorderseite durch Freilegung der Kante vor. Ferner beschreibt die Patentschrift DE 102 25 935 B4 die punktuelle, fortlaufende Kontaktierung des Substrats an der Kante. Keine dieser Druckschriften beschreibt jedoch das Herstellen niederohmiger Kontakte zwischen der HTS-Schicht und dem Substrat eines HTS-Bandleiters.

Üblicherweise geschieht die Kontaktierung der HTS-Schicht und dem Substrat des HTS-Bandleiters durch eine Schicht aus einem guten metallischen Leiter, der auf die HTS-Schicht und die offen liegenden Seitenflächen und die Rückseite des Bandleiters aufgebracht wird. Diese Schicht stellt gleichzeitig die elektrische Kontaktschicht zur HTS-Schicht dar, durch die elektrischer Strom in die HTS-Schicht ein- und ausgekoppelt wird. Als unmittelbare Kontaktschicht dienen normalerweise Edelmetalle wie Ag, Au bzw. Legierungen dieser Elemente, die an der Grenzfläche zum Supraleiter nicht oxidieren. Die Beschichtung kann durch chemische und physikalische Verfahren erfolgen. Normalerweise wird die Schicht beidseitig bzw. rundherum im Vakuum auf den HTS-Bandleiter aufgedampft oder gesputtert.

Während sich dadurch ein akzeptabler elektrischer Kontakt zur HTS-Schicht herstellen lässt, bereitet der Kontakt zum Metallsubstrat jedoch Probleme. Die Depositionsprozesse der HTS-Schichten und teilweise auch der Pufferschichten finden nämlich typischerweise bei hohen Temperaturen > 600 °C und unter Sauerstoffeinwirkung statt, d.h. in einer oxidierenden Atmosphäre. Durch diese Hochtemperaturprozesse oxidieren, bzw. verzundern die offen liegenden Kanten und die Rückseite des Metallsubstrats. Es bilden sich auf der Oberfläche zumindest in Teilbereichen des Metallsubstrats elektrisch schlecht oder nicht leitende Metalloxidschichten, u.a. aus $NiO$, $Cr_2O_3$, $Fe_2O_3$ etc.

Die leitfähige Kontaktschicht wird zwar weiterhin häufig noch mit Kupfer oder anderen Metallen verstärkt, z.B. durch galvanisches Aufdicken oder das Auflöten von einer Metallfolie, dies ändert aber nichts am schlechten Grenzflächenkontakt zwischen der Edelmetallschicht und dem Metallsubstrat des HTS-Bandleiters und dem damit verbundenen hohen Übergangswiderstand.

Durch seitliches Schleifen, Besäumen oder Längsteilen des Bandleiters, d.h. durch Aufschneiden in schmalere Leiter vor der rundum-Beschichtung mit Silber, wie in EP 2 490 273 A1 dargestellt, werden frische Schnittkanten erzeugt, über die der elektrische Kontakt zustande kommt.

Zudem wird der HTS-Bandleiter nach der Abscheidung der Silberschicht in Sauerstoffatmosphäre bei Temperaturen > 300 °C ausgelagert. Vorzugsweise werden Temperaturen > 500 °C angewandt. Dadurch wird zum einen durch Diffusion von Silber in die oberflächennahe Oxidschicht eine Verbesserung der Haftung und des Kontakts erreicht, zum anderen diffundiert Sauerstoff durch die Silberschicht in die HTS-Schicht, so dass diese mit Sauerstoff beladen wird und sich dadurch die supraleitende, orthorhombische Phase ausbildet.

Das Eindiffundieren von Silber in die Zunderschicht auf der Substratrückseite kann zu punktuellen Kontakten und einer leichten Verbesserung des elektrischen Kontakts zwischen der Silberschicht und dem Metallsubstrat führen. Damit kann jedoch keine zuverlässige, niederohmige Verbindung hergestellt werden. Gleiches gilt für den Kontakt über die sehr schmalen Kanten des Substrats wie in EP 1 639 609 B1 nahegelegt. Da die typische Breite von HTS-Bandleitern 3 - 12 mm beträgt, ist die Oberfläche der HTS-Schicht, aus der der Strom abgeleitet werden muss im Vergleich zur Randfläche der Substratkante, die nur eine Dicke von 30 - 150 $\mu$m hat, um mehr als eine Größenordnung kleiner. Eine Stromumverteilung über die Substratkante erfordert also längere Strecken der Randfläche des Substrats und kann nicht lokal erfolgen.

Eine weitere Gefahr der Zunderschicht zwischen Substratrückseite und Metallisierung besteht in der Beeinträchtigung der mechanischen Haftung. Da die Struktur der Oxidschicht im Wesentlichen amorph und porös ist, stellt sie bei mechanischer Belastung eine Sollbruchstelle dar und kann zur Delamination der Metallisierung von der Substratrückseite führen. Solche mechanischen Belastungen treten u.a. durch unterschiedliche thermische Ausdehnungen des Substrats und der Metallschicht auf (Bimetalleffekt) oder in gewickelten Magnetspulen infolge des Vergusses, der thermischen Ausdehnung und der magnetische Kräfte.

Das Entfernen einer Zunderschicht, die während einer Warmbehandlung eines Metalls entstanden ist, ist schon seit langer Zeit bekannt. Zum Entzundern von Metallen werden diese häufig in ein Säurebad getaucht bzw. gebeizt. Für einen HTS-Bandleiter scheidet dieser Prozess aufgrund der empfindlichen HTS- und Pufferschichten aus.

Ferner ist es ebenfalls bereits bekannt, Laserstrahlung zum Entfernen einer Oxidschicht von einer Metalloberfläche zu einzusetzen. So beschreibt beispielsweise die EP 0 927 595 B1 das Verwenden eines freien Elektronenlasers FEL (Free Electron Lasers) zum Abtragen einer Zunderschicht von einer Metalloberfläche. Zudem werden $CO_2$- (Kohlenstoffdioxid) Laser (vgl. US 4 720 621), Nd:YAG Laser (vgl. UR-Lhttp://www.ilt.fraunhofer.de/en/publication-and-press/brochures/brochure_Laser_Cleaning.html) und Excimer-Laser (vgl. JP-A-2 197 588) zum Entzundern von Metallen eingesetzt.

Keines dieser Dokumente berücksichtigt jedoch, dass ein Metallband mit einer Oxidschicht auf seiner Rückseite auf seiner Vorderseite mehrere empfindliche Funktionsschichten aufweist, die durch den Prozess des Entzunderns nicht beschädigt werden dürfen.

Beispiele möglicher Beschädigungs- bzw. Zerstörungsquellen von Funktionsschichten sind deren Überhitzung bzw. die Einwirkung mechanischer Schockwellen.

Der vorliegenden Erfindung liegt daher das Problem zu Grunde, ein Verfahren und eine Vorrichtung zum Herstellen eines Hochtemperatur-Supraleiters anzugeben, dessen Kontaktschicht einen niedrigen Übergangswiderstand zum Substrat des Hochtemperatur-Supraleiters aufweist.

Die DE 10 2013 210 940 B3 betrifft ein Verfahren zum Aufbringen einer Glättungsschicht auf ein Bandsubstrat zum nachfolgenden Herstellen eines Hochtemperatur-Supraleiter-Bandleiters, das die Schritte aufweist: (a) Aufbringen einer Polysilazan enthaltenden Flüssigkeit auf eine Temperatur $\geq$ 450°C zum Abscheiden einer Schicht, die Siliziumoxinitrid $SiN_xO_y$, mit $0 \leq x$ 0,6 und $1,0 < y \leq 2$) und/oder Siliziumcarbooxinitrid ($SiC_x$-$N_yO_z$, mit $2 \cdot y < x \leq 1,0$, $0 < y < 0,2$ und $1,0 < z \leq 2,0$) aufweist auf den Bandsubstrat.

Die US 2007 / 0 111 893 A1 offenbart einen supraleitenden Draht, der eine erste und eine zweite supraleitende Schicht umfasst, die auf einem oder mehreren Substraten in gestapelter Form angeordnet sind. Die erste supraleitende Schicht umfasst ein erstes Hochtemperatur-supraleitendes Oxid einer ersten Zusammensetzung und eine zweite supraleitende Schicht einer zweiten Zusammensetzung, wobei die erste und die zweite Zusammensetzung verschieden sind. Die erste Supraleiterschicht schließt optional eine Hochtemperatur-Supraleiter-Zusammensetzung ein, die ausgewählt wird, um einen erhöhten kritischen Strom ($I_c(c)$) bei Anwesenheit eines Magnetfeldes senkrecht zur Oberfläche der Supraleiterschicht (H//c) bereitzustellen. Die zweite Supraleiterschicht umfasst optional eine Hochtemperatur-Supraleiter-Zusammensetzung, die ausgewählt wird, um einen erhöhten kritischen Strom ($I_c$) bei Anwesenheit eines Magnetfeldes parallel zur Oberfläche der Supraleiterschicht (H//ab) bereitzustellen.

Das US Patent mit der Nr. 5 948 172 bezieht sich auf eine Vorrichtung, die Laserstrahlung verwendet, um eine Oxidschicht (Zunder) durch Verdampfen von einem heiß gewalzten oder weichgeglühten Streifen zu entfernen, wobei der Streifen in einer gravitativ vertikalen Richtung mit einer Geschwindigkeit von zumindest 10 m/min bewegt wird. Die Vorrichtung umfasst einen Hochleistungs-Laser, wie etwa einen Freien-Elektronen-Laser und eine abgeschlossene Wechselwirkungskammer, die ein nicht oxidierendes Gas enthält. Die elektromagnetische Strahlung des Lasers weist eine Oberflächen-Leistungsdichte von mindestens 5 MW/cm$^2$ am Auftreffpunkt auf die Oberfläche des Metallstreifens auf. Die Strahlung hat eine Pulsbreite von weniger als 100 ps, eine Pulswiederholrate von mehr als 10 MHz und dien mittlere Leistung von wenigstens 10 kW.

Die JP 2003 205601 beschreibt das Anbringen einer Hochtemperatur-Supraleiter-Schicht, wie beispielsweise HoBCO, auf beiden Seiten eines Metallbandes, das beispielsweise Nickel, eine Nickel-Eisen Legierung und einen Nickel-Verbundwerkstoff umfasst. Zwischen das Metallband und die Hochtemperatur-Supraleiter-Schicht eine Metalloxid-Zwischenschicht, beispielsweise aus YSZ und $CeO_2$ angebracht. Vor dem Anbringen der Metalloxid-Zwischenschichten wird eine Oxidschicht von dem Metallband mittels eines Vakuum-Reduktionsofens entfernt.

Die US 2004 / 0 266 628 A1 offenbart eine supraleitendes Band, das ein Substrat, eine auf dem Substrat angeordnet Pufferschicht, eine auf der Pufferschicht angeordnete supraleitende Schicht eine galvanisch auf die supraleitende Schicht aufgebrachte Stabilisierungsschicht.

### 3. Zusammenfassung der Erfindung

Gemäß einem Ausführungsbeispiel der vorliegenden Erfindung wird dieses Problem durch ein Verfahren nach Anspruch 1 gelöst.

In dieser Anmeldung wird eine Isolatorschicht als eine Schicht definiert, die einen größeren Widerstand als das darunterliegend metallische Substrat aufweist. Äquivalent zu dieser Definition weist eine Isolatorschicht in dieser Anmeldung eine spezifische Leitfähigkeit auf, die geringer als die des metallischen Substrats ist. Beispiele derartiger Isolatorschichten sind dünne Oxid- und/oder Nitridschichten. Ferner kann beispielsweise eine Isolatorschicht in Form einer Oxidschicht neben einem Metall und Sauerstoff geringe Anteile weiterer Elemente enthalten.

Ein erfindungsgemäßes Verfahren ermöglicht es, eine Kontaktschicht auf der Rückseite des Substrats eines Hochtemperatur-Supraleiters (HTS) zu erzeugen, die einen deutlich verbesserten Kraftschluss im Vergleich zum Anbringen einer Kontaktschicht auf eine Isolatorschicht des Substrats aufweist. Damit verringert ein erfindungsgemäßes Aufbringen der Kontaktschicht auf das metallische Substrat eines HTS eine Beschädigung der Kontaktschicht beispielsweise durch deren Delamination während des weiteren Prozessierens oder des Einsatzes des HTS. Ferner erlaubt ein erfindungsgemäßes Verfahren das Erzeugen eines zuverlässigen elektrischen Kontakts zwischen der HTS-Schicht und dem zugehörigen Substrat mit einem sehr geringen Übergangswiderstand. Dadurch wird verhindert, dass zwischen der HTS-Schicht und dem metallischen Substrat Potentialdifferenzen auftreten können, deren elektrische Felder die elektrisch nicht oder schlecht leitenden Pufferschicht(en) und /oder die HTS-Schicht und damit den Hochtemperatur-Supraleiter zerstören. Ein nach einem erfindungsgemäßen Verfahren hergestellter HTS kann somit zum reproduzierbaren Schalten zwischen dem supraleitenden und normalleitenden Zustand eingesetzt werden.

Der Schritt b. wird unter Verwendung eines Lasers durchgeführt, dessen Strahl auf die Isolatorschicht auf der Rückseite des metallischen Substrats gerichtet ist.

Der Einsatz eines Lasers zum Entfernen einer Zunderschicht hat den Vorteil, dass dessen Betriebsparameter an die zu entfernende Isolatorschicht und / oder an das darunter liegende Substrat des HTS angepasst werden können. Dies ermöglicht ein Entfernen der Isolatorschicht von der Rückseite des Substrats, ohne die empfindlichen Funktionsschichten auf der Substratvorderseite, d.h. die Zwischen- oder Pufferschicht(en) und die HTS-Schicht zu beschädigen.

Gemäß einem anderen Aspekt ist der Laser ausgebildet, Laserpulse mit Pulsdauern kleiner 100 ns, vorzugsweise kleiner 10 ns, mehr bevorzugt kleiner 1 ns, und am meisten bevorzugt kleiner 10 ps zu erzeugen.

Nach einem weiteren Aspekt weist der Strahldurchmesser des Laserstrahls beim Auftreffen auf die Isolatorschicht einen Durchmesser größer 10 $\mu$m, bevorzugt größer 50 $\mu$m auf.

In einem vorteilhaften Aspekt ist die Leistungsdichte des Laserstrahls beim Auftreffen auf die Isolatorschicht größer als 100 MW·cm$^{-2}$, bevorzugt großer größer als 300 MW·cm$^{-2}$, und mehr bevorzugt größer als 1 GW·cm$^{-2}$.

Kurze energiereiche Laserpulse deponieren eine große Menge Energie in extrem kurzer Zeit in einer dünnen Oberflächenschicht, beispielsweise einer Isolatorschicht und heizen diese lokal oder selektiv sehr schnell auf hohe Temperaturen auf. Das erhitzte Material dehnt sich lokal sehr schnell aus und wird damit vom Untergrund, d.h. von der Rückseite des Metallsubstrats weggesprengt oder sogar verdampft.

Nach einem weiteren günstigen Aspekt liegt die Wellenlänge des Lasers im nahen ultravioletten Bereich, im sichtbaren Bereich oder im nahen infraroten Bereich zwischen 150 nm - 2000 nm, bevorzugt zwischen 200 nm - 1200 nm.

Die Wellenlänge und die Pulsdauer des Laserstrahls werden so gewählt, dass die Energie der Laserpulse vorwiegend in oder unmittelbar unter der zu entfernenden Isolatorschicht absorbiert wird. Dadurch wird sichergestellt, dass sich das metallische Substrat in seinem Inneren nicht signifikant aufheizt. Je kürzer die Wellenlänge der Laserstrahlung ist, desto geringer ist die Eindringtiefe der elektromagnetischen Strahlung in eine Isolatorschicht, insbesondere in eine Oxidschicht. Dies bedeutet, dass mit geringer werdender Wellenlänge der Anteil der Energie der Laserpulse, der in einer dünnen Isolatorschicht deponiert wird, zunimmt. Damit ermöglicht kurzwellige Laserstrahlung das Verwenden von hohen Leistungsdichten und damit einhergehend großen Abtragraten ohne die Funktionsschichten auf der Vorderseite des HTS-Substrats signifikant thermisch zu belasten.

Ferner kann durch eine entsprechende Wahl der Wellenlänge und der Pulsdauern das Entstehen von Schockwellen in dem metallischen HTS-Substrat verhindert werden, die die auf der Vorderseite des Substrats angebrachten Pufferschicht(en) und/oder die HTS-Schicht beschädigen oder zerstören könnten.

Der Abtrag der Isolatorschicht erfolgt vorzugsweise durch lokale Erwärmung nur der Isolatorschicht, wodurch das Material explosionsartig verdampft und zusätzlich weiteres Material in dessen Nähe wegsprengt. Alternativ kann die Laserstrahlung auch mit einer dünnen Oberflächenschicht des metallischen Substrats wechselwirken, die dadurch in dünner Schicht aufschmilzt und verdampft. In diesem Fall wird das verdampfende Metall die darüber liegende Isolatorschicht wegsprengen. In beiden Fällen liegt die Pulsenergiedichte über der Verdampfungsschwelle (Zerstörungsschwelle) für das jeweilige Material.

In einem vorteilhaften Aspekt weisen benachbarte Pulse eine laterale Überlappung ihrer Auftreffflächen auf der Isolatorschicht von 0 % - 50 %, bevorzugt 0 % - 30 %, und am meisten bevorzugt 10 % - 20 % auf.

Wenn wirtschaftliche Zwänge außer Betracht gelassen werden können, kann eine Isolatorschicht mit Hilfe von Laserpulsen im Wesentlichen vollständig entfernt werden. In einem wirtschaftlichen Umfeld ist jedoch die Geschwindigkeit, mit der eine Isolatorschicht von dem Substrat eines HTS entfernt werden kann, die entscheidende Größe. Ein erfindungsgemäßes Verfahren kann deshalb dahingehend optimiert werden, dass einerseits nach dem Entfernen der Isolatorschicht eine Kontaktschicht mit geringem Übergangswiderstand auf das Substrat abgeschieden werden kann und andererseits die Flächenrate, mit der die Isolatorschicht entfernt wird, möglichst hoch wird. In diesem Spannungsfeld kann es sinnvoll sein, geringe Teile der Isolatorschicht beispielsweise zwischen den einzelnen Laserpulsen auf der Rückseite des metallischen Substrats zu belassen, solange dadurch die Funktion der Kontaktschicht nicht beeinträchtigt wird.

Der Begriff "im Wesentlichen" bedeutet hier wie an anderen Stellen dieser Beschreibung, die Angabe einer Größe innerhalb üblicher Fehlergrenzen.

Gemäß noch einem anderen Aspekt ist ein zeitlicher Abstand zwischen dem Auftreffen von zwei Pulsen an einer gleichen Stelle der Isolatorschicht größer als 1 $\mu$s, bevorzugt größer als 50 $\mu$s, und am meisten bevorzugt größer 100 $\mu$s.

Durch den zeitlichen Abstand wird sichergestellt, dass sich das Substrat nicht mehr als notwendig lokal erwärmt. Dadurch kann verhindert werden, dass thermische Spannungen zwischen dem metallischen Substrat und den Funktionsschichten so groß werden, dass sie den HTS beschädigen können.

Nach einem weiteren vorteilhaften Aspekt weist ein nach dem Schritt b. auf der Rückseite des metallischen Substrats verbleibender Rest der Isolatorschicht eine Struktur auf, die im Wesentlichen durch Betriebsparameter des Lasers bestimmt wird.

Damit erzeugen die Laserpulse in der Regel eine Signatur in dem verbleibenden Rest der Isolatorschicht die charakteristisch für den Prozess des Entfernens der Isolatorschicht ist.

Nach einem anderen günstigen Aspekt kann nach dem Schritt b. die Rückseite des metallischen Substrats oberflächlich eine Rissstruktur aufweisen.

Eine typische Rissstruktur entsteht durch thermische Kontraktion beim Erstarren und Abkühlen der in dünner Schicht angeschmolzenen Metalloberfläche. Die Risse ziehen sich dabei bis in eine Tiefe von 50 bis 500 nm zur Grenzfläche zwischen aufgeschmolzenem und festem Material.

Ein weiteres Merkmal des oberflächlichen Aufschmelzens ist eine glatte, strukturlose Grenzfläche zwischen dem Substrat und der durch die Laserbestrahlung aufgeschmolzenen Schicht.

Zur Erzielung einer großen Flächenabtragrate (Flächenabtrag pro Zeiteinheit) kann es günstig sein, den räumlichen Abstand des Auftreffpunkts von benachbarten Laserpulsen auf die Substratschicht so zu wählen, dass deren Auftreffflächen nur zu einem geringen Ausmaß oder gar nicht überlappen. Der räumliche Abstand kann vergrößert werden, so lange der Übergangswiderstand der nachfolgend aufgebrachten Kontaktschicht nicht ansteigt. Durch den räumlichen Abstand benachbarter Laserpulse und die Wahl der weiteren Betriebsparameter des Lasersystems entsteht normalerweise ein typisches Muster von Rückständen der Isolatorschicht auf der Rückseite des HTS-Substrats.

In noch einem anderen Aspekt wird die entfernte Isolatorschicht abgesaugt oder weggeblasen.

Das Entfernen der durch den Laserbeschluss von der Oxidschicht weggesprengten Trümmer verhindert, dass sich diese an anderer Stelle der Oxidschicht oder auf der HTS-Schicht absetzen können und damit den Bandleiter verschmutzen und nachfolgende Prozessschritte beeinträchtigen können. Darüber hinaus kühlt der durch das Absaugen oder Wegblasen entstehende Luftstrom die durch die Laserbestrahlung lokal erhitzte Oberfläche des metallischen Substrats.

Nach einem weiteren Aspekt ist das metallische Substrat als ein flächiges Substrat ausgebildet, vorzugsweise als ein Bandleiter.

Nach einen günstigen Aspekt weist die auf der Rückseite im Schritt c. aufgebrachte Kontaktschicht einen flächenspezifischen Übergangswiderstand zwischen dem metallischen Substrat und der Kontaktschicht von weniger $10^{-3}$ $\Omega \cdot cm^2$ auf.

Der flächenspezifische Übergangswiderstand $R_A$ beschreibt den auf eine Flächeneinheit bezogenen Übergangswiderstand $R$. Für eine vorgegebene Kontaktfläche $A$ ergibt sich der Übergangswiderstand aus dem flächenspezifischen Übergangswiderstand gemäß:

$$R = \frac{R_A}{A}.$$

Durch den Übergangswiderstand weist das in dieser Anmeldung definierte Verfahren eine Messgröße auf, mit deren Hilfe das Verfahren für verschiedene Anwendungsbereiche optimiert werden kann. Falls ein im Wesentlichen vollständiger Abtrag der Isolatorschicht im Fokus steht, kann dieser durch einen sehr kleinen Übergangswiderstand nachgewiesen werden. Eine nur teilweise oder eine unzureichende Entfernung der Isolatorschicht spiegelt sich in einem höheren Übergangswiderstand zwischen der Kontaktschicht und der Rückseite des HTS-Substrats wieder.

In jedem Fall führt das Reinigen der Rückseite des Bandleiters (d.h. das Entfernen eiern Oxidschicht) vor dem Aufbringen der metallischen Kontaktschicht jedoch zu einem definierten Übergangswiderstand ohne große Messwertstreuung. Hingegen weisen ungereinigte Substrate (d.h. Substrate deren Oxidschicht nicht entfernt wurde) abhängig von den lokalen Gegebenheiten unter der Kontaktfläche eine große Streuung der gemessenen Übergangswiderstände auf. Bei einer resistiven Messung liegt das 1/f Rauschen dadurch um mindestens eine Größenordnung über dem Rauschanteil einer wie oben beschrieben behandelten Bandleiter-Rückseite.

Nach noch einem weiteren Aspekt wird der Schritt b. im Vakuum oder in einer Schutzgasatmosphäre durchgeführt.

Dieser Aspekt kann weitgehend verhindern, dass sich während des Bearbeitungsprozesses des Schrittes b. erneut eine dünne Isolatorschicht, insbesondere eine Oxidschicht auf der Rückseite des Substrats bildet.

In einem besonders günstigen Aspekt wird ein Hochtemperatur-Supraleiter hergestellt mit einem Verfahren nach einem der oben angegebenen Aspekte, wobei die Kontaktschicht einen flächenspezifischen Übergangswiderstand zwischen dem metallischen Substrat und der Kontaktschicht von weniger $10^{-3}\,\Omega\cdot cm^2$ aufweist.

Nach noch einem weiteren Aspekt umfasst das Aufbringen einer elektrisch leitfähigen Kontaktschicht eine Temperaturbehandlung der elektrisch leitfähigen Kontaktschicht bei einer Temperatur oberhalb 300 °C für eine Zeitdauer von mindestens 10 Minuten in einer Umgebungsatmosphäre. Gemäß einem anderen günstigen Aspekt weist die elektrisch leitfähige Kontaktschicht eine Haftabzugsfestigkeit größer als 1 MPa auf.

Durch das Aufbringen und eine Temperaturbehandlung der Kontaktschicht entsteht zwischen der Substratrückseite und der Kontaktschicht zudem eine besonders innige mechanisch belastbare Verbindung mit einer großen Haftabzugsfestigkeit.

Eine Vorrichtung zum erfindungsgemäßen Herstellen eines Hochtemperatur-Supraleiters wird durch Anspruch 12 definiert.

Gemäß einem weiteren Aspekt umfassen die Mittel zum teilweisen Entfernen einer Isolatorschicht ein Transportsystem für einen Hochtemperatur-Supraleiter-Bandleiter.

Nach noch einem anderen Aspekt umfasst die Vorrichtung ferner Mittel zum Durchführen eines Verfahrens nach einem der oben angegebenen Aspekte. In einem weiteren Aspekt umfassen die Mittel zum teilweisen Entfernen einer Isolatorschicht einen ersten Laser zum teilweisen Entfernen einer Isolatorschicht und einen zweiten Laser, der Strahlung im sichtbaren Wellenlängenbereich emittiert, zum Ausrichten des ersten Lasers auf die Rückseite des metallischen Substrats. Schließlich weist ein anderer Aspekt zumindest eine Kamera zum Beobachten des zumindest teilweisen Entfernens der Isolatorschicht auf.

## 4. <u>Beschreibung der Zeichnungen</u>

In der folgenden detaillierten Beschreibung werden derzeit bevorzugte Ausführungsbeispiele der Erfindung unter Bezugnahme auf die Zeichnungen beschrieben, wobei

Fig. 1 schematisch einen prinzipiellen Aufbau (im Querschnitt) eines Hochtemperatur-Supraleiter (HTS)-Bandleiters ohne Kontakt- und Stabilisierungsschicht zeigt;

Fig. 2 schematisch den HTS-Bandleiter der Fig. 1 nach dem Anbringen einer Kontaktschicht gemäß dem Stand der Technik darstellt;

Fig. 3a schematisch einen Längsschnitt durch eine Vorrichtung repräsentiert, mit deren Hilfe eine Isolatorschicht von der Rückseite eines Substrats entfernt werden kann;

Fig. 3b ein Bild der Prozesskammer der Vorrichtung der Fig. 3a wiedergibt;

Fig. 4 eine schematische Aufsicht auf die Rückseite des Metallsubstrats zeigt, in der Scan-Bereiche des Lasersystems der Fig. 3a dargestellt sind;

Fig. 5a einen Ausschnitt einer Oberfläche einer Oxidschicht (vorwiegend bestehend auf Magnesiumoxid) einem Metallsubstrat zeigt;

Fig. 5b eine Ausschnitt der Oberfläche einer anderen Oxidschicht (Zunderschicht) auf einem Metallsubstrat darstellt;

Fig. 6a einen Ausschnitt eines Querschnitts eines metallischen Substrats mit der Oxidschicht aus der Fig. 5a wiedergibt;

Fig. 6b einen Ausschnitt eines Querschnitts eines metallischen Substrats mit der Oxidschicht der Fig. 6b repräsentiert

Fig. 7a einen Ausschnitt der Rückseite eines Metallsubstrats zeigt, deren Oxidschicht mit einem Laser bearbeitet wurde;

Fig. 7b     einen Ausschnitt einer Rückseite eines Metallsubstrats darstellt, deren oberer Teil der Oxidschicht mit Laserpulsen bearbeitet wurde und deren unterer Teil die Oxidschicht vor der Einwirkung der Laserpulse zeigt;

Fig. 8a     einen Ausschnitt der Rückseite eines Metallsubstrats mit höherer Auflösung zeigt, deren Oxidschicht mit einem Laser bearbeitet wurde, wobei die Oberfläche der Metallschicht eine Rissbildung zeig, die typisch für das Erstarren der lokalen Schmelze ist, die im Fokus eines Laserstrahls erzeugt wird;

Fig. 8b     einen Ausschnitt der Rückseite eines Metallsubstrats mit höherer Auflösung darstellt, deren Oxidschicht (Zunderschicht) mit einem Laser bearbeitet wurde, wobei die Oberfläche der Metallschicht Spuren von Rissbildung zeigt, die typisch für das Erstarren der lokalen Schmelze ist, die im Fokus eines Laserstrahls erzeugt wird;

Fig. 9a     ein erstes Beispiel einer Querschnittsaufnahme wiedergibt, die einen Übergang von einer dicken Oxidschicht (links) zeigt, die mit einem Laser bearbeitet wurde (rechts);

Fig. 9b     die Querschnittsaufnahme analog zur Fig. 9a mit größerer Auflösung wiedergibt;

Fig. 9c     die Querschnittsaufnahme der behandelten Zunderschicht aus der Fig. 8b mit größerer Auflösung wiedergibt;

Fig. 10     schematisch den prinzipiellen Aufbau (im Querschnitt) des HTS-Bandleiters der Fig. 1 nach dem Entfernen der rückseitigen Oxidschicht und dem Aufbringen einer Kontaktschicht auf die Rückseite des Metallsubstrats darstellt;

Fig. 11     die Querschnittsaufnahme der Rückseite des Metallsubstrats aus der Fig. 9c nach Laserbehandlung, Aufbringen einer Silber-Kontaktschicht und anschließender Wärmebehandlung wiedergibt;

Fig. 12     den HTS-Bandleiter der Fig.10 nach dem Strukturieren der rückseitigen Kontaktschicht wiedergibt, damit zeigt die Fig. 12 die Messgeometrie zum Bestimmen des Übergangswiderstands;

Fig. 13     Messpunkte der Widerstände als Funktion des Abstands zwischen den Messpunkten auf der Substratrückseite für eine nach Fig. 12 präparierte Probe präsentiert;

Fig. 14     den HTS-Bandleiter der Fig. 1 nach dem Strukturieren einer auf die rückseitige Oxidschicht aufgebrachte Kontaktschicht wiedergibt;

Fig. 15     Messkurven der Widerstände als Funktion des Abstands zwischen den Messpunkten auf der Substratrückseite gemäß der Fig. 14 wobei die Oxidschicht dieser Proben anders als in der Fig. 12 nicht entfernt wurde;

Fig. 16     schematisch den prinzipiellen Aufbau (im Querschnitt) des HTS-Bandleiters der Fig. 1 nach dem Entfernen der rückseitigen Oxidschicht und dem Aufbringen einer Kontaktschicht, die die HTS-Schicht mit dem metallischen Substrat verbindet, zeigt; und

Fig. 17     die Fig. 16 nach dem Aufbringen einer durchgängigen vollflächigen Stabilisierungsschicht um das HTS-Bandleitersystem veranschaulicht.

## 5. Detaillierte Beschreibung bevorzugter Ausführungsbeispiele

Im Folgenden werden derzeit bevorzugte Ausführungsbeispiele eines Verfahrens zum Herstellen eines Hochtemperatur-Supraleiters (HTS) beispielhaft anhand eines HTS-Bandleiters und einer Vorrichtung für dessen Herstellung erläutert. Nachfolgend wird als Hochtemperatur-Supraleiter-Bandleiter (HTS-Bandleiter) oder auch nur Bandleiter eine supraleitende Leiterkonfiguration bezeichnet, die auf einem flexiblen Metallsubstrat bzw. einer flexiblen Metallsubstratfolie basiert, auf das eine oder mehrere Zwischenschichten und mindestens eine HTS-Schicht als supraleitende, stromführende Funktionsschicht aufgebracht werden.

Es versteht sich, dass ein erfindungsgemäßes Verfahren bzw. eine erfindungsgemäße Vorrichtung nicht auf die dargestellten Beispiele beschränkt sind. Vielmehr kann ein erfindungsgemäßes Verfahren zum Entzundern von Metallsubstraten beliebiger Hochtemperatur-Supraleiter eingesetzt werden. Darüber hinaus ist es möglich, ein erfindungsgemäßes Verfahren zum Entfernen von Isolatorschichten von dünnen Metallfolien einzusetzen, die empfindliche Funktionsschichten aufweisen.

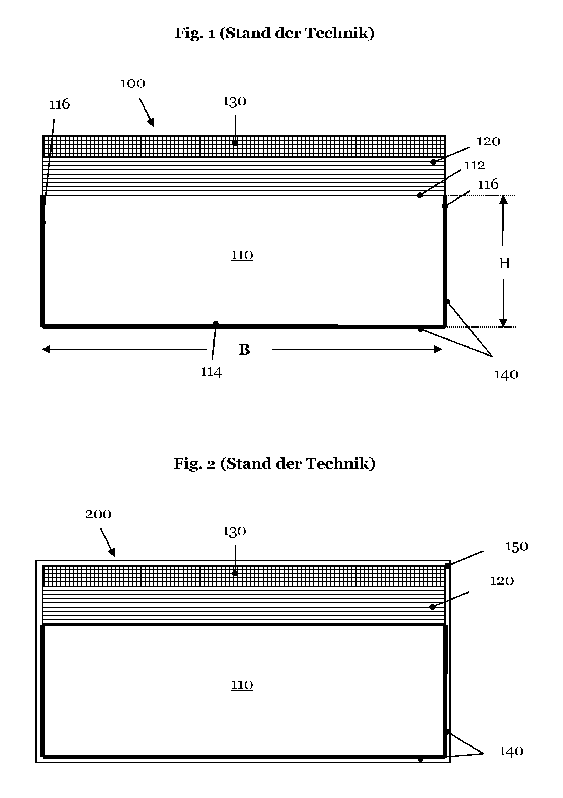

Die Fig. 1 zeigt schematisch einen Querschnitt einer Grundform oder Basisversion 100 eines HTS-Bandleiters. Eine HTS-Schicht 130 muss als eine orientierte, epitaktische Schicht abgeschieden werden. Üblicherweise werden zur Abscheidung orientierter, epitaktischer Schichten einkristalline Substrate benötigt, die die Anordnung der Atome in der Schicht und damit deren kristalline Orientierung vorgeben. Da solche Substrate sehr teuer sind und nicht in beliebiger Größe zur Verfügung stehen, werden häufig kostengünstige technische Substrate wie die in dieser Anmeldung beschriebenen Metallbleche, -folien oder -bänder als Substrat oder als Basismaterial zur Herstellung von Hochtemperatur-Supraleitern verwendet.

Um die in technischen Substraten fehlende kristallographische Orientierung herzustellen, wurden zum einen Verfahren zum biaxialen Texturieren der Unterlage durch Walz- und Glühschritte, sogenanntes RABiTS Verfahren (Rolling Assisted Bi-axially Textured Substrate), als auch spezielle Beschichtungsverfahren zur Erzeugung von bi-axial orientierten Pufferschichten 120 entwickelt, die als Epitaxieunterlage zum Abscheiden der HTS-Schicht 130 dienen können. Ein etablierter Beschichtungsprozess ist das IBAD- (Ion Beam Assisted Deposition) Verfahren, bei dem während der Deposition ein unterstützender Ionenstrahl unter einem bestimmten Winkel auf die Substratoberfläche 110 gerichtet wird. Basisvarianten dieses Verfahrens sind in der EP 0 872 579 A1 und der EP 1 178 129 A1 beschrieben. Bei dem ISD- (Inclined Substrate Deposition) Verfahren - einem anderen gängigen Prozess - erfolgt die Beschichtung aus der Gasphase unter einem Winkel auf ein gekipptes Substrat. Dieses Verfahren ist in der EP 0 669 411 A1 und der EP 0 909 340 A1 ausgeführt.

Die Grundform 100 des HTS-Bandleiters der Fig. 1 umfasst eine dünne Metallfolie als Substrat 110, die typischerweise mehr als 80 % der Gesamtdicke der Grundform 100 des HTS-Bandleiters ausmacht. Übliche Substratmaterialien sind Legierungen aus mindestens zwei der Elemente Nickel (Ni), Chrom (Cr), Eisen (Fe), Molybdän (Mo), Mangan (Mn), Wolfram (W), Vanadium (V) etc., wie z.B. Ni mit Beimischungen von 3-10 % W, Ni mit Beimischungen von 5-15 % Cr, Hastelloy™ C 276, Haynes™ 242, oder Edelstähle wie SUS™ 310, SUS™ 410, Monel™ oder Inconel™. Die Dicke oder Höhe H des Metallsubstrats 110 liegt typischerweise im Bereich von 30 $\mu$m - 200 $\mu$m. Die Breite B des Metallsubstrats 110 umfasst einen Bereich von 3 mm bis 100 mm.

Auf dem Metallsubstrat 110 werden vorzugsweise eine oder mehrere Pufferschichten 120 angeordnet, die u.a. zur Haftvermittlung, als Diffusionsbarrieren, und - wie in den vorhergehenden Abschnitten erläutert - zur Erzeugung bzw. zum Übertragen einer kristallinen Orientierung dienen. Üblicherweise weist die geglättete Vorderseite 112 des Substrats 100 eine RMS (Route Mean Square) Rauigkeit von weniger als 10 nm auf. Auf kurzen Skalen von wenigen Mikrometern beträgt die Rauigkeit der Vorderseite 112 des Substrats 110 bevorzugt weniger als 1 nm. Auf die Vorderseite 112 werden eine oder zumeist mehrere Zwischen- oder Pufferschichten 120 abgeschieden. Bei den Pufferschichten 120 handelt es sich mehrheitlich um Metalloxide wie z.B. Magnesiumoxid (MgO), Ceroxid (CeO$_2$), Aluminiumoxid (Al$_2$O$_3$), Yttriumoxid (Y$_2$O$_3$), oder Mischoxide wie z.B. Yttrium-stabilisiertes Zirkonoxid (YSZ), Gd$_2$Zr$_2$O$_7$, La$_2$Zr$_2$O$_7$, LaMnO$_3$, SrTiO$_3$. Gelegentlich kommen auch Metallnitride wie Titannitrid (TiN) zum Einsatz.

Aufgrund ihrer Zusammensetzung stellen die Pufferschichten 120 sowohl einzeln als auch in ihrer Abfolge als Multilagen gute elektrische Isolatoren, bzw. schlechte elektrische Leiter dar, so dass ein direkter elektrischer Stromfluss zwischen einer HTS-Schicht 130 und dem Metallsubstrat 110 unterbunden wird. Die Pufferschichten 120 haben normalerweise zusammengerechnet eine Dicke bzw. Höhe zwischen 100 nm und einigen Mikrometern.

Auf der bzw. den Pufferschicht(en) 120 folgt die eigentliche HTS-Funktionsschicht 130, die in der supraleitenden Anwendung den Strom trägt und typischerweise eine Dicke von 0,5 $\mu$m - 10 $\mu$m aufweist. Bevorzugt liegt die HTS-Schichtdicke 130 im Bereich von 1,5 $\mu$m - 5 $\mu$m. HTS-Schichten 130 bestehen aus RBa$_2$Cu$_3$O$_7$, wobei R für Yttrium, ein Element aus der Gruppe der seltenen Erden oder Mischungen aus mindestens zwei dieser Elemente steht. Zudem kann die Stöchiometrie der HTS-Schicht 130 in gewissen Grenzen - typischerweise innerhalb $\pm$ 10% - von der idealen 1:2:3 Zusammensetzung abweichen.

Ein wichtiger Bestandteil der HTS-Schicht 130 ist Sauerstoff. Somit erfolgt das Deponieren der HTS-Schicht 130 in einer Umgebung die Sauerstoff enthält. Ferner erfolgt das Abscheiden der HTS-Schicht 130 bei hohen Temperaturen (über 650 °C). Unter diesen Bedingungen bildet sich auf den offen liegenden Kanten 116 und der Rückseite 114 des metallischen Substrats 110 eine dünne Oxidschicht 140 oder anders ausgedrückt, die Kanten 116 und die Rückseite 114 des Metallsubstrats 110 verzundern. Auch bei der Abscheidung der Pufferschichten 120 auf der Substratvorderseite 116 kann durch Streuung im Restgas isolierendes Material auf die Kanten und die Rückseite 114 des Substrats 110 gelangen und dieses mit einer Schicht 140 belegen. Des Weiteren ist es möglich, dass die Rückseite 114 absichtlich mit einer dünnen Sauerstoffundurchlässigen Schicht 140 (z.B. MgO) beschichtet wird, um ein starkes Verzundern während der Hochtemperaturprozesse zu verhindern. In jedem Fall wirken sich diese Schichten hinderlich bei der Kontaktierung der Substratrückseite 114 aus und sollten deshalb vor Aufbringen einer Kontaktschicht 150 ganz oder zumindest teilweise entfernt werden.

Das direkte Aufbringen einer Kontaktschicht 150 auf die HTS-Schicht 130 und die Kanten 116 sowie der Rückseite 114 des Substrats 110 resultiert ohne Entfernen der Oxidschicht 140 in einem großen Übergangswiderstand zwischen der Kontaktschicht 150 und dem Metallsubstrat 110. Die Kontaktschicht 150 ist in der Fig. 2 schematisch dargestellt. Die Oxidschicht 140 verursacht die im einleitenden Teil diskutierten Probleme.

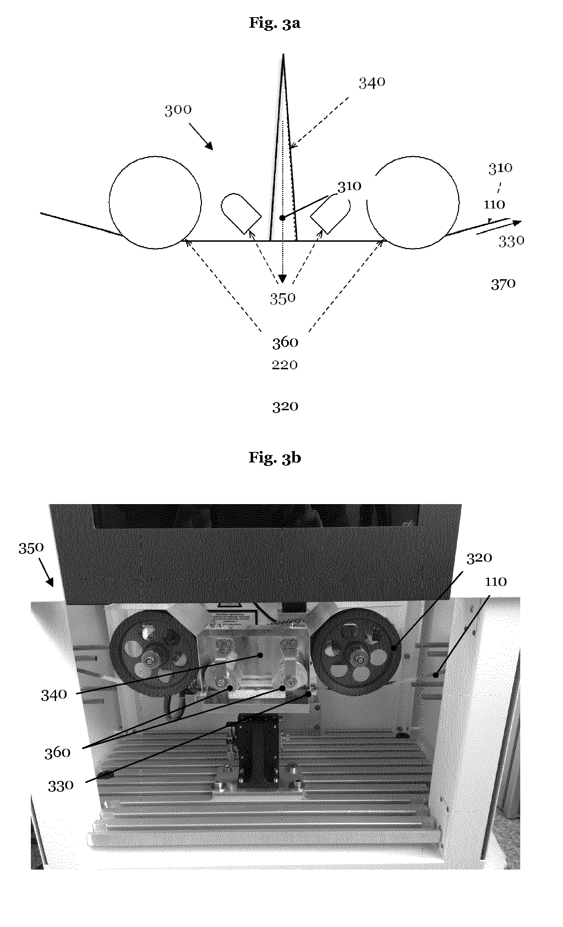

Die Fig. 3 zeigt schematisch einen Schnitt durch eine beispielhafte Vorrichtung 300 mit deren Hilfe die Oxidschicht 140 von der Rückseite 114 des metallischen Substrats 110 entfernt werden kann. In dem in der Fig. 3 dargestellten Beispiel wird für das Abtragen der Oxidschicht 140 (Entzunderung) ein Nd:YVO$_4$-Laser (ein Yttrium-Vanadat Laser (YVO$_4$) mit Neodym Dotierung) der Firma Rofin benutzt (Rofin PL E10). Der Nd:YVO$_4$-Laser

emittiert Licht mit einer Wellenlänge von 1064 nm. Er weist einen einstellbare Pulswiederholfrequenz von 0-200 kHz bei einer mittleren Leistung von 10 W auf. Die Pulsdauer beträgt ca. 10 ns. Der Laserstrahl 310 des Nd:YVO$_4$-Lasers kann mit Hilfe eines Galvo Scanners das Substrat 110 in einer programmierbaren Form rastern (in der Fig. 3 nicht dargestellt). In der Fig. 3 symbolisieren die Linien 340 einen Schnitt durch den Scan-Bereich in der Längsrichtung des Metallsubstrats 110.

Der Pfeil 350 in der Fig. 3 gibt die Transportrichtung des Metallsubstrats 110 an. Die Absaugvorrichtung 360 ermöglicht das Entfernen der durch den Laserstrahl 370 von der Rückseite 114 des Metallsubstrats 110 abgesprengten Trümmer der Oxidschicht 140.

Der Prozessbereich in der Prozesskammer 340 kann mit einer Kamera, beispielsweise einer CCD (Charge-Coupled Device) Kamera beobachtet werden (in der Fig. 3 nicht gezeigt). In dem Beispiel der Fig. 3 kann ein Pilotlaser, der Licht im sichtbaren Bereich des Spektrums emittiert, zum Positionieren des Nd:YVO$_4$-Lasers benutzt werden (beispielsweise ein He-Ne (Helium-Neon) Laser oder ein Halbleiter-Laser).

Die Fig. 3a zeigt einen Blick in eine existierende reale Apparatur 350. Das zu prozessierende Metallsubstrat 110 wird über die Umlenkrollgen 320 und den Eintrittspalt 330 in das Innere der Prozesskammer 340 geleitet. Im Inneren der Prozesskammer 340 sind die Absaugdüsen 360 angebracht, die das von dem Laserstrahl 310 abgetragene Material absaugen. Der Laserstrahl 310 (nicht sichtbar) wird von oben an die Rückseite 114 des Metallsubstrats 110 geführt.

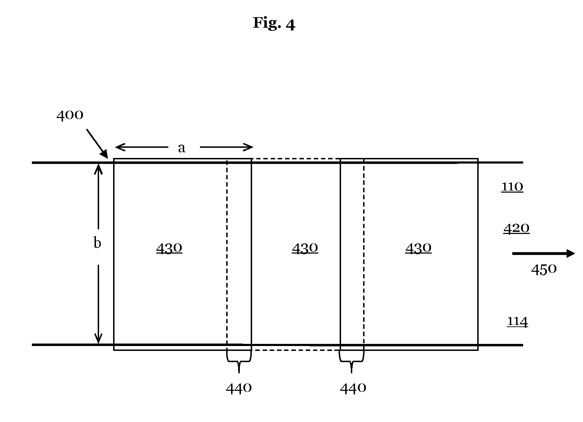

Die Fig. 4 veranschaulicht das Scannen oder Rastern des Laserstrahls 310 über ein metallisches Substrat 110 eines HTS-Bandleiters. Die Fig. 4 zeigt eine Aufsicht auf die Rückseite 114 des Metallsubstrats 110. Während eines Scan-Vorgangs des Lasers bewegt sich das Metallband 110 kontinuierlich. Dies ist in der Fig. 4 durch den Pfeil 450 symbolisiert. Der Galvo Scanner des Lasersystems rastert den Laserstrahl 310 zeilenweise über ein Rechteck 430 mit der Fläche $a \cdot b$. In dem Beispiel der Fig. 4 weist das Rechteck eine Länge $a$ = 12,0 $mm$ (in Längsrichtung des Bandes) und eine Breite $b$ = 13,5 $mm$ auf, so dass das Rechteck den Bandleiter seitlich leicht überlappt. Nach Abschluss des Scan-Vorgangs des Rechtecks 430 springt der Galvo Scanner auf das nächste Rechteck 430 in Transportrichtung 450 vorwärts und rastert den Laserstrahl 310 über das nächste Rechteck 430 mit den oben angegebenen Abmaßen. Durch Wählen einer Überlappung 440 der einzelnen Scan-Bereiche von 2 mm wird sichergestellt, dass die Oxidschicht 140 von der gesamten Rückseite 114 des Metallsubstrats 110 lückenlos behandelt wird.

Wie bereits oben ausgeführt, ist es bevorzugt, die Betriebsparameter des Lasers zum Entfernen der Oxidschicht 140 auf die Oxidschicht und/oder das Metallsubstrat 110 abzustimmen. Im Folgenden wird der Prozess der Optimierung der Betriebsparameter des in der Fig. 3 erläuterten Lasersystems erläutert. Dieser Prozess ist beispielhaft für den oben erwähnten des Nd:YVO$_4$-Lasers. Er dient lediglich dazu, das Prinzip des Optimierens der Laser-Betriebsparameter zu erläutern. Beispielsweise kann anstelle des Lasers der Fig. 3 ein Excimer-Laser eingesetzt werden. Ein Excimer-Laser weist zumindest zwei Vorteile auf: (a) aufgrund der kürzeren Wellenlänge (im ultravioletten Wellenlängenbereich) wird ein sehr viel größerer Anteil der Laserstrahlung 310 in der Oxidschicht 140 auf der Rückseite 114 des Metallsubstrats absorbiert. (b) Excimer-Laser können deutlich größere Pulsenergien erzeugen als der Nd:YVO$_4$-Laser der Fig. 3. Dadurch kann ein Strahl mit einem größeren Durchmesser erzeugt werden und somit gleichzeitig eine größere Fläche bestrahlt werden. Allerding ist ein entsprechender Excimer-Laser sehr viel teuer verglichen mit dem in der Fig. 3 beschriebenen Lasersystem.

Um den Entzunderungsprozess für den beispielhaften Nd:YVO$_4$-Laser so wirtschaftlich wie möglich zu gestalten, soll das Entfernen der Oxidschicht 140 von der Rückseite 114 des Metallsubstrats 110 mit einer Geschwindigkeit von mindestens 20 m/h erfolgen. Für eine Breite des Metallsubstrats von $b$ = 12,0 $mm$ ergibt dies eine Flächenabtragrate der Oxidschicht 140 von 0,24 m$^2$/h.

Im ersten Schritt wurden die Betriebsparameter des Lasersystems oder die Laser-Parameter bei stehendem Bandwickler, d.h. ohne Transport des Metallsubstrats variiert und die Ergebnisse wurden visuell verglichen, um ein grobes Gefühl zu bekommen, welche Parameter zu besseren Ergebnissen bei der Entfernung der Oxidschicht 140 führen. Im Folgenden wird das Entzundern, bzw. die Entfernung der Oxidschicht von der Rückseite 114 des Metallsubstrats 110 auch Reinigen des Metallsubstrats 110 genannt. Es wurde festgestellt, dass niedrigere Puls-Wiederholraten und geringe Scan-Geschwindigkeiten (d.h. Geschwindigkeit der Laserstrahlbewegung in dem Rechteck 430) zu besseren Ergebnissen beim Abtragen der Oxidschicht 140 führen. Für den beispielhaften Laser der Fig. 3 ergeben nur Puls-Wiederholraten von weniger als 20 kHz eine ausreichende Pulsenergie für einen sichtbaren Entzunderungs- oder Reinigungserfolg, d.h. für ein sichtbares Entfernen der Oxidschicht 140 von der Rückseite 114 des Metallsubstrats 110.

Die Pulsenergie steigt mit abnehmender Puls-Wiederholrate, weil zwischen zwei Pulsen mehr Zeit zur Energiesammlung im Aktivmedium des Lasersystems bleibt. Bei Puls-Wiederholraten von 10 kHz beträgt die Zeitspanne zwischen zwei Pulsen 0,1 ms; diese Zeit entspricht ungefähr der Lebensdauer des oberen Zustands des Laserübergangs im aktiven Medium des Nd:YVO$_4$-Lasers. Eine Verringerung der Puls-Wiederholrate $R_P$ unter 10 kHz führt zu keiner höheren Pulsenergie, weil die spontane Emission einen weiteren Anstieg der aus der Pumpenergie gesammelten Energie im aktiven Medium verhindert.

Bei einer Puls-Wiederholrate von $R_P$ = 20 $kHz$

reicht die Energie eines Laserpulses aus, um die Oxidschicht 140 effektiv abzutragen. Bei Scan-Geschwindigkeiten des Laserstrahls 310 innerhalb des Rechtecks 430 die kleiner sind als 1000 mm/s beginnen sich benachbarte Laser-Spots (d.h. Auftreffflächen der Laserpulse auf die Oxidschicht 140) zu überlappen, wenn der Laserstrahl 310 auf einen *Durchmesser d* = 100 μm fokussiert ist. Der Abstand *s* zwischen benachbarten Spots beträgt:

$$s = \frac{v_{Scan}}{v} = \frac{10^3 \frac{mm}{s}}{10^4 \, Hz} = 100 \mu m \,.$$

Derart niedrige Scan-Geschwindigkeiten sind allerdings für eine dynamische Reinigung der Rückseite 114 des Metallsubstrats 110 bei akzeptablen Bandgeschwindigkeiten oder Flächenabtragraten nicht bevorzugt. Die weiteren Untersuchungen wurden dynamisch durchgeführt, wobei die Scan-Geschwindigkeit erhöht und gleichzeitig die Puls-Wiederholrate verringert wurde bis ein Entfernen der Oxidschicht 140 mit der geforderten Mindest-Bandgeschwindigkeit von 20 m/h möglich war. Erst bei einer Scan-Geschwindigkeit von 1000 mm/s und einer Frequenz von 10 kHz bzw. bei einer Scan-Geschwindigkeit von 1300 mm/s und einer Puls-Wiederholrate von 15 kHz konnte das vorgegebene Ziel erreicht werden.

Als Scan-Bereich wurde das in der Fig. 4 dargestellte Rechteck 430 gewählt. Das Rechteck 430 entsteht dabei durch das Aneinanderreihen von Linien, die quer zur Bandlängsrichtung gerastert werden. Die Breite der Schraffur-Linien ist ein Eingabe-Parameter des Lasersystems der Fig. 3. Sie sollte dem Durchmesser des Laser-Spots entsprechen (hier ca. 75 μm). Die eingegebene Breite der Schraffur-Linien zusammen mit deren Überlappung, die auch einstellbar ist, hat Einfluss auf den Abstand zwischen den Schraffur-Linien. Ein kleinerer Abstand benachbarter Schraffur-Linien bzw. eine größere Überlappung verbessert das Entfernen der Oxidschicht 140 von der Rückseite 114 des Metallsubstrats, begrenzt aber andererseits die erreichbare Bandgeschwindigkeit bzw. allgemeiner die Flächenabtragrate.

Die erreichbare Bandgeschwindigkeit *v*$_{Band}$ ergibt sich aus der Scan-Geschwindigkeit *v*$_{Scan}$, der Linienlänge *l* (entspricht der Breite *b* des Rechtecks 430), der Breite der Linie w (d.h. dem Durchmesser des Laserstrahls 310 beim Auftreffen auf die Oxidschicht) und der Überlappung p , wobei die Überlappung der Schraffur-Linie in Längsrichtung des Metallbandes beschreibt. Die nachfolgende Gleichung stellt die Bandgeschwindigkeit *v*$_{Band}$ als Funktion der angegebenen Größen dar:

$$v_{Band} = \frac{v_{Scan}}{l} \cdot w \cdot (1 - p) \,.$$

In der Realität kann diese Bandgeschwindigkeit nicht erreicht werden, da im "On-the-fly"-Modus, d.h. beim Rastern von Rechtecken auf bewegtem Substrat, der Abstand benachbarter Rechtecke 430 kleiner sein muss als die Breite der einzelnen Rechtecke, um - wie im Kontext der Fig. 4 diskutiert - eine lückenlose Überdeckung des Metallbandes 110 durch den Laserstrahl 310 zu gewährleisten.

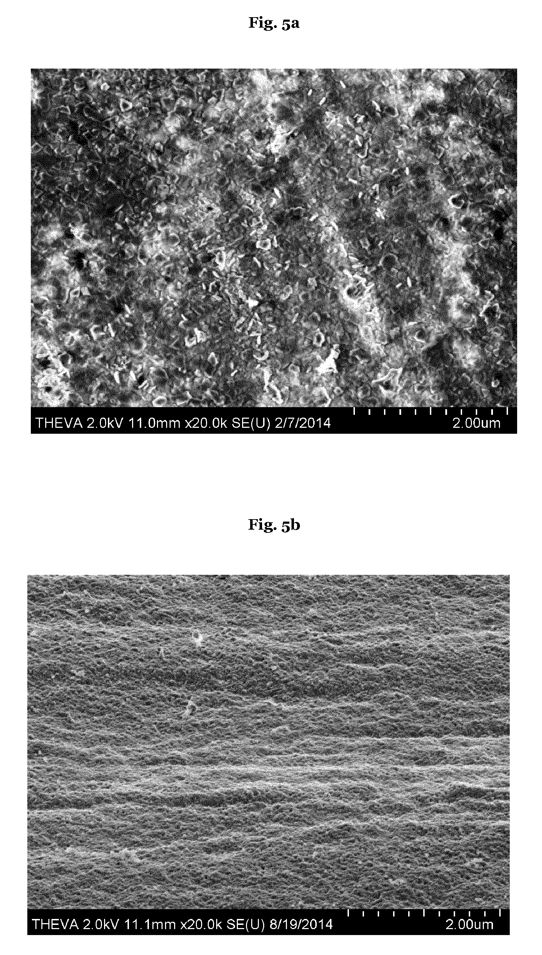

Die Figuren 5a und 5b zeigen die Oberflächen von Substratrückseiten 114 mit unterschiedlichen Oxidschichten 140 im RasterElektronenmikroskop bei 20000-facher Vergrößerung. In Fig. 5a handelt es sich im Wesentlichen um MgO, was bei der Deposition der Pufferschicht 120 auf die Rückseite 114 gelangt. Bei der Fig. 5b handelt es ich um eine verzunderte (oxidierte Hastelloy™ C276 Oberfläche. In beiden Fällen ist die Oxidschicht 140 sehr rau.

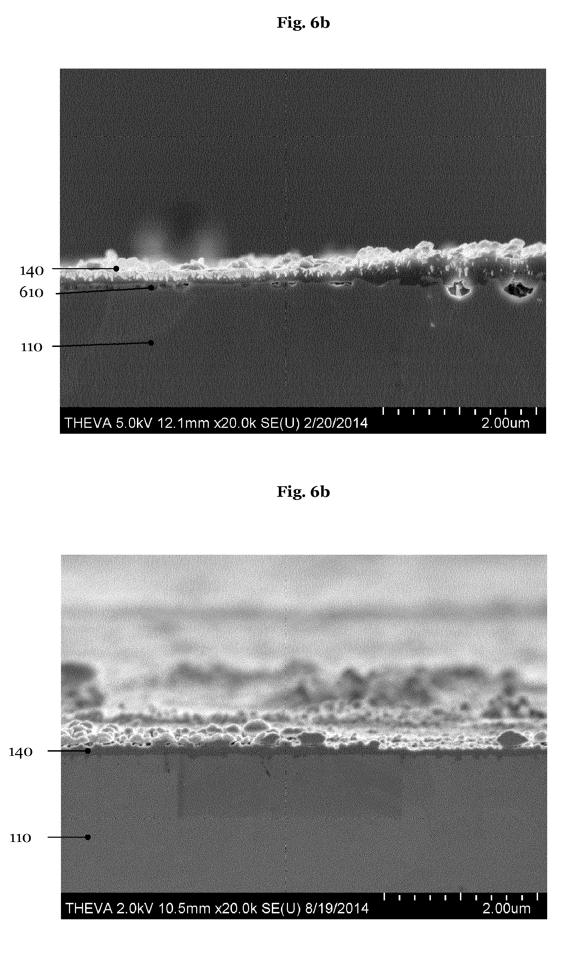

Die Figuren 6a und 6b zeigen Querschnitte durch die Oberflächen der Figuren 5a und 5b. Unterhalb der MgO-Oxidschicht 140 haben sich in der Fig. 6a durch Diffusion in die Oberfläche 114 des Metallsubstrats 110 hinein Poren 610 gebildet, die die Haftung der Oxidschicht 140 auf dem Metallsubstrat 110 beeinträchtigen. Auch in der Fig. 6b ist die Grenzfläche zwischen Oxidschicht 140 und Substrat 110 geprägt durch eine unregelmäßige Rautiefe von bis zu 50 nm. Die Dicke der Oxidschicht 140 liegt im Bereich von weniger als einem Mikrometer.

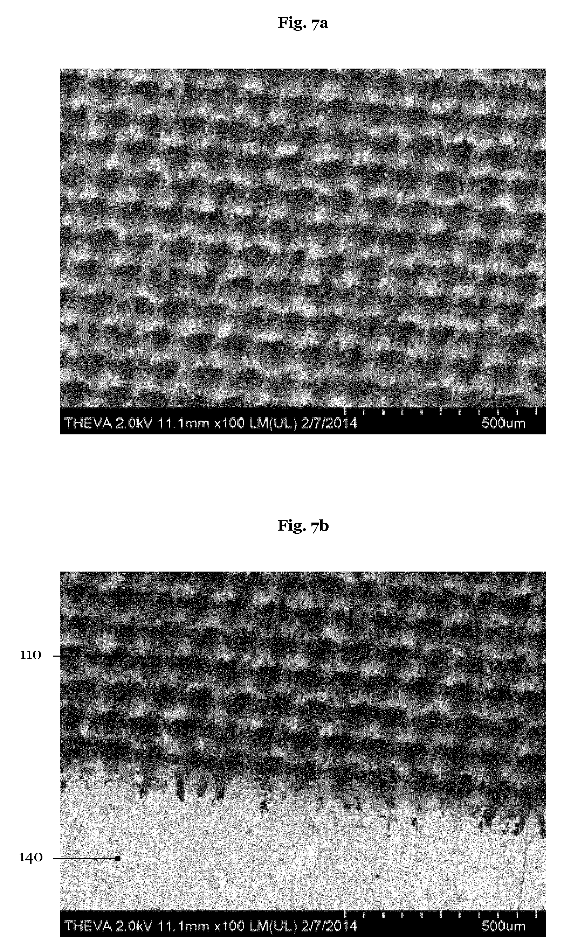

Die Fig. 7a zeigt eine Laser-gereinigte Rückseite 114 eines Metallsubstrats 110 bei niedriger 100-facher Vergrößerung im Rasterelektronenmikroskop (REM). In dem in der Fig. 7a dargestellten Beispiel wurde der Laser mit einer Pulsfrequenz von 10 kHz, einem Pulsabstand von 100 μm und einer Scangeschwindigkeit von 1000 m/s gerastert.

Die Fig. 7b repräsentiert eine REM-Aufnahme mit der im vorhergehenden Abschnitt angegebenen Vergrößerung, bei der im unteren Teil die Oxidschicht 140 noch vorhanden ist (heller Bereich), während im oberen Teil die Oxidschicht 140 durch Laserpulse weitgehend entfernt wurde (dunkler Bereich). Der Übergang zwischen mit Oxid bedeckter Rückseite 114 und gereinigter Fläche ist deutlich erkennbar. Deutlich erkennbar ist auch das für das Reinigungsverfahren charakteristische Punktraster. In den zentralen Bereichen des Laserfokus wurde die Oxidschicht vollständig entfernt und das Metallsubstrat 110 (dunkele Bereiche) freigelegt.

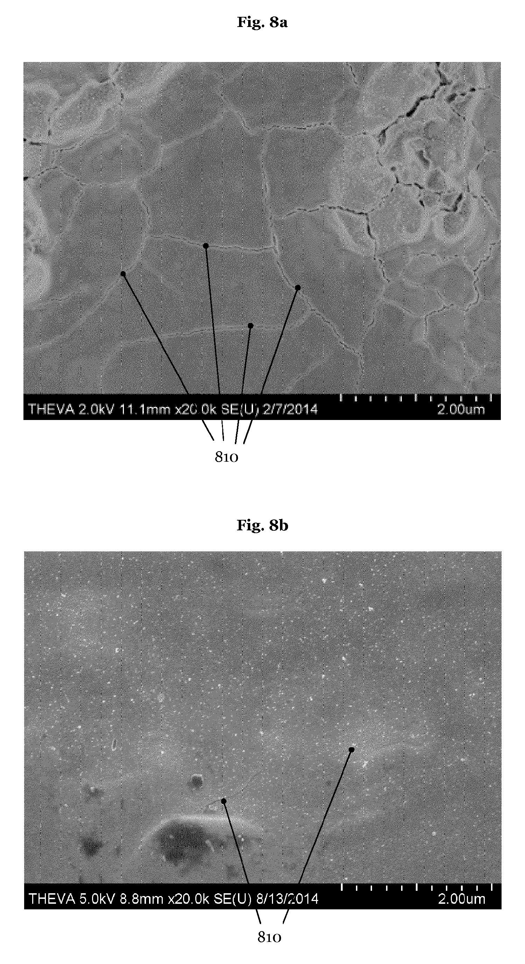

Die Figuren 8a und 8b zeigen in starker Vergrößerung (20000-fach) den zentralen Fokusbereich eines Laserpulses auf der bestrahlten Rückseite 114 eines Metallsubstrats 110. In dem Beispiel der Fig. 8a wurde die MgO-Schicht der Fig. 5a mit dem Laser behandelt. Sie ist geprägt durch das charakteristische Auftreten von Rissen 810 in der Oberfläche des Metallsubstrats 110. Die Oberfläche wurde offenbar durch den Laserbeschuss bis in geringe Tiefe angeschmolzen. Beim Erstarren und schnellen Abkühlen der Schmelze traten durch einen Schrumpfungsprozess Spannungen auf, die durch Oberflächen-nahe Risse 810 relaxierten. Die Fig. 8b zeigt die Laser-behandelte Oberfläche der Fig. 5b. Auf hier treten vereinzelt Abkühlungsrisse 810 in der Oberfläche 810 auf.

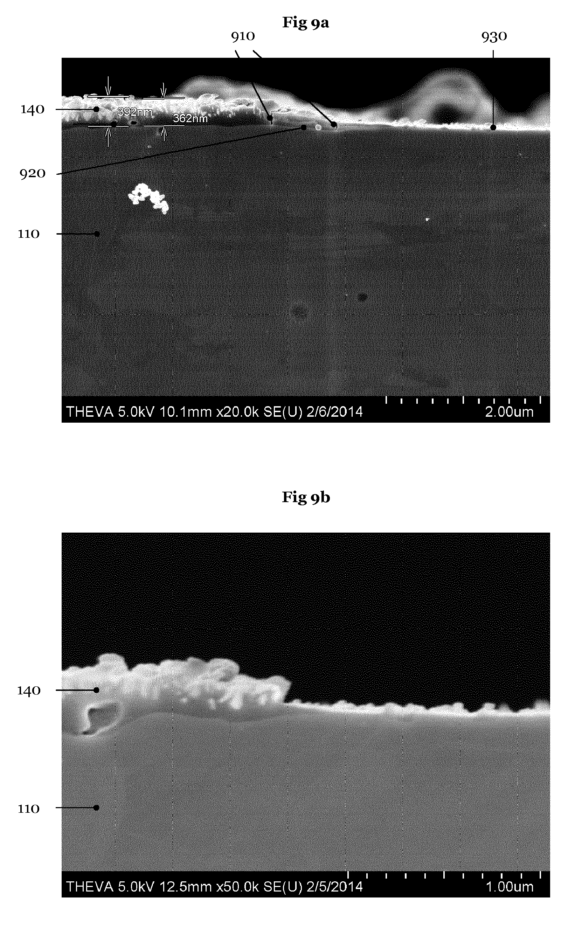

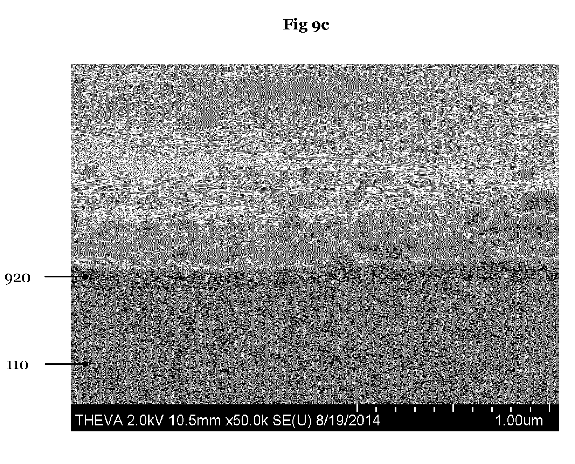

Die Figuren 9 und 9b zeigen in unterschiedlichen Vergrößerungen Querschnittspräparationen eines Metallsubstrats 110 mit einer Oxidschicht 140 analog zu der Fig. 6a Oberflächen-nahen Übergangsbereich zwischen Zunder- bzw. Oxidschicht 140 und dem Bereich 930, in dem diese Oxidschichten 140 mit Hilfe von Laserpulsen weitgehend entfernt wurden. In der Fig. 9a ist in der linken Bildhälfte bei 20000- flacher Vergrößerung die 300 nm bis 400 nm dicke Oxidschicht 140 deutlich zu erkennen. Die Fig. 9b zeigt einen Ausschnitt der Fig. 9a mit 50000-facher Vergrößerung. Ferner ist in dem zentralen Bildbereich eine aufgeschmolzene Schicht 920 zu erkennen, die zwei Risse 910 aufweist, die von der Oberfläche der verbliebenen Oxidschicht bis an die rückseitige Grenzfläche 114 des Metallsubstrats 110 reichen.

Die Fig. 9C zeigt die Laser-behandelte Zunderschicht analog zu der Fig. 6b bei 50000-facher Vergrößerung. Auch hier ist eine aufgeschmolzene Oberflächenschicht 920 sichtbar. Im Unterschied zu der Fig. 6b ist die Grenzfläche zwischen der Oberflächensicht 920 und dem Substrat 110 glatt und strukturlos.

Nachfolgend wird der komplette Parametersatz des eingesetzten Lasersystems aufgelistet:

> Laserleistung: $\leq$ 10 W
> Pulsdauer: ca. 10 ns
> Wellenlänge: 1064 nm
> Fokusdurchmesser: $\leq$100 $\mu$m
> Pulsfrequenz: 10 kHz
> Pulsenergie: $\leq$ 1 mJ
> Pulsenergiedichte: $1,27 \cdot 10^5$ J/m$^2$
> Pulsleistung: 100 kW
> Scangeschwindigkeit: 1000 mm/s

Überlappung benachbarter Schraffur-Linie: 20% (bei einem Fokusdurchmesser von 100$\mu$m)

> Abstand benachbarter Pulse in der Schraffur-Linie: 100 $\mu$m
> Maximale Bandgeschwindigkeit: <20 m/h

Einige wichtigste Kriterien zum Beurteilen des Erfolgs des Entfernens der Oxidschicht oder für die Charakterisierung der Reinigungsergebnisse sind die Werte des Übergangswiderwiderstands zwischen der Kontaktschicht 150 und dem Metallsubstrat 110 des HTS-Bandleiters und/oder die Haftfestigkeit der auf die Rückseite 114 aufgebrachten Kontaktschicht. Nachfolgend werden zunächst Ergebnisse der Messung des Übergangswiderstands präsentiert.

Wie oben beschrieben, wurde die Oxidschicht 140 von der Rückseite 114 des Metallsubstrats 110 entfernt. Die Reinigung wurde mit einer Bandgeschwindigkeit von 18 m/h durchgeführt. Der Wiederholabstand im "On-the-fly"-Modus war 10 mm (vgl. Fig. 4). Der Scan-Bereich des Laserstrahls 310 umfasste ein 13,5 mm breites und 12 mm langes Rechteck 430. Damit wurde sichergestellt, dass immer ein Überlapp von 2 mm zwischen benachbarten Rechtecken 430 eingehalten wird.

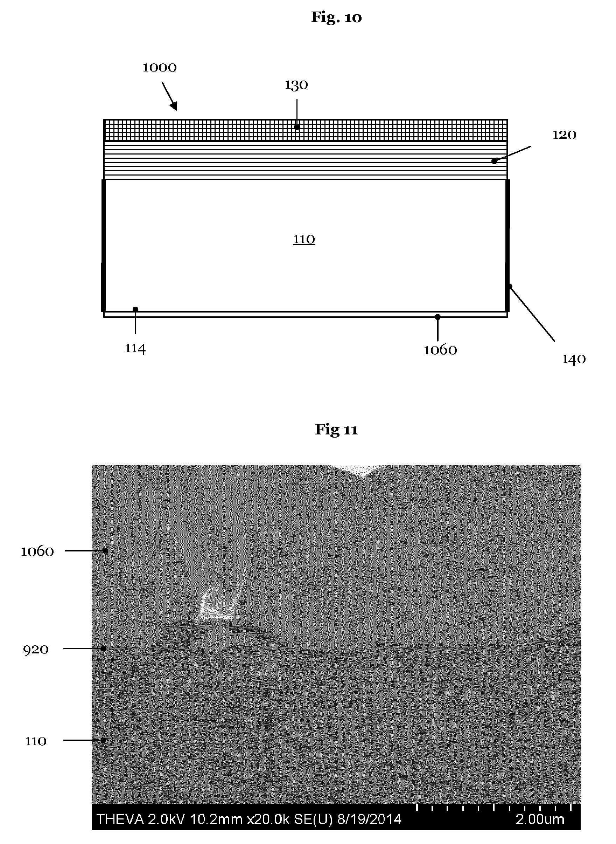

Wie in der HTS Konfiguration 100 der Fig. 10 dargestellt ist, wird die Rückseite 114 des Metallsubstrats 110 nach dem Entfernen der Oxidschicht 140 mit einer Kontaktschicht 1060 aus Silber beschichtet. Neben Silber können für die Kontaktschicht andere Edelmetalle wie etwa Gold und Legierungen aus Edelmetallen eingesetzt werden. Um die Haftfestigkeit der Kontaktschicht 10960 zu verbessern, wurden die Proben für zwei Stunden auf 200 °C aufgeheizt.

Die Fig. 11 zeigt einen Querschnitt durch eine Substratrückseite eines HTS-Bandleiters, der nach der Laser-Behandlung mit einer Silber-Kontaktschicht 1060 von 2,5 $\mu$m bis 3 $\mu$m Dicke beschichtet und zwischen 600 - 300 °C in Sauerstoffatmosphäre für 12 Minuten getempert wurde. Bei dieser Temperatur kommt es zu einer deutlichen Verzahnung zwischen der aufgeschmolzenen Oberflächenschicht 920 und der Silberschicht 1060, während die Grenzfläche zum Substrat 110 unberührt bleibt.

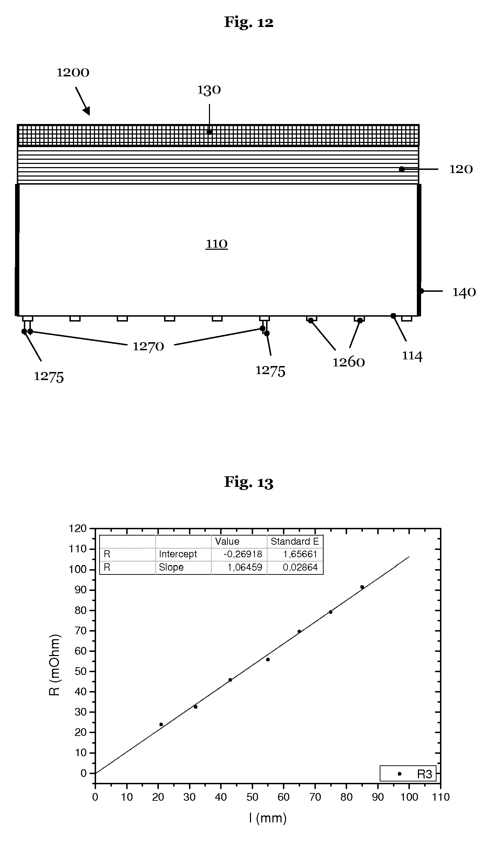

Die Silberschicht 1060 wurde dann mittels einer silberätzenden Lösung bis auf mehrere ca. 7x5 mm$^2$ große Silber-Kontaktflächen 1060, die im Abstand von jeweils ca. 1 cm angeordnet sind, entfernt. Die HTS-Bandleiter Konfiguration 1200 der Fig. 12 zeigt die Konfiguration 1000 der Fig. 10 nach Abschluss des Ätzprozesses. Die Silber-Kontaktflächen 1260 werden als Kontakte für die Widerstandsmessungen benutzt.

Die Widerstände zwischen den Messpunkten 1260 auf der Rückseite 114 des Metallsubstrats 110 werden mit verschiedenen Abständen entlang der Probe mit einem Keithley 2700 Multimeter in Vier-Punkt-Geometrie gemessen. Die Anschlüsse 1275 dienen zum Einprägen eines definierten Stroms. Mit Hilfe der Anschlüsse 1270 wird der Spannungsabfall zwischen den Silber-Kontaktflächen 1260 gemessen. Die Kontakte für die Strom-1275 und die Spannungsmessung 1270 werden für jeden Messpunkt zusammen auf je eine Silber-Kontaktfläche 1260 gelötet Der Messfehler für eine Einzelmessung beträgt etwa 100 $\mu\Omega$. Vierpunktmessungen waren deshalb nötig, um die Leitungswiderstände zu eliminieren. Zum Vergleich wurden auch Zweipunktmessungen durchgeführt. Diese ergaben um ca. 200 m$\Omega$ größere Werte, was in etwa dem Leitungswiderstand entspricht.

Der mit Vierpunktmessungen gemessene Widerstand zwischen den Silber-Kontaktflächen 1260 ist die Summe der Übergangswiderstände zwischen den Silber-Kontaktflächen 1260 und dem Metallsubstrat 110 und des Widerstand des Metallsubstrats 110. Der Widerstand des Metallsubstrats wächst linear mit dem Abstand I der Messpunkte, d.h. dem Abstand der Silber-Kontaktflächen 1260. Die Übergangwiderstände hingegen sollten bei konstanter Größe der Kontakte und homogener rückseitiger Oberfläche 114 konstant sein.

Ein typisches Messergebnis nach dem Entfernen der Oxidschicht 140 ist in der Fig. 13 dargestellt. Bei einem Punktrasterabstand der Pulse ≤ 100 μm beginnen sich die zentralen, gereinigten Flächen der Einzelpulse zu überlappen und die gemessenen Widerstände sind weitgehend unabhängig von Scanparametern wie der Scangeschwindigkeit, dem Linienabstand und der Überlappung der Pulse. Wie erwartet, steigt der Widerstand linear als Funktion des Abstands *l*. Der Schnittpunkt der Geraden mit der y-Achse, der der Summe der Übergangswiderstände entspricht, liegt reproduzierbar in der Nähe des Ursprungs (0 mΩ), innerhalb einer Fehlerbreite von weniger als 1,6 mΩ·cm².

Aus der Steigung der Gerade von 1,06 mΩ/mm lässt sich ein spezifischer Substratwiderstand von 130 μΩ·cm ableiten, was sehr gut mit dem Literaturwert von Hastelloy™ C 276 übereinstimmt. Die Widerstandmessungen nach der Laser-Reinigung sind an unterschiedlichen Proben gut reproduzierbar und belegen, dass sich durch die Laser-Reinigung und Silberbeschichtung nach dem beschriebenen Verfahren gut definierte Übergangswiderstände zwischen dem Metallsubstrat 110 und Silberschicht 960 mit < 1 mΩ·cm² ohne große Messwertstreuung erreichen lassen.

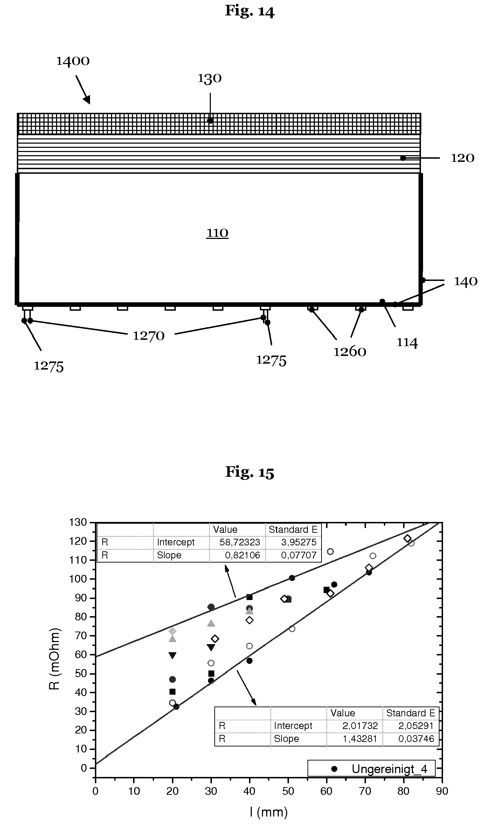

Zu Vergleichszwecken wurde eine Silber-Schicht auf eine unbehandelte Oxidschicht 140 aufgebracht und wie oben beschrieben strukturiert. Die Fig. 14 veranschaulicht diese Konfiguration 1400.

Die Widerstandsmessungen an ungereinigten Substraten sind in Fig. 15 dargestellt. Die unterschiedlichen Symbole bezeichnen Messreihen zwischen unterschiedlichen Proben und Kontaktflächen und streuen erheblich, so dass sich keine eindeutig lineare Abhängigkeit vom Abstand ergibt. D.h. die Kontaktwiderstände unter den einzelnen Kontaktflächen weichen stark voneinander ab und streuen um bis zu 40 mΩ. Ohne das erfindungsgemäße Reinigungs- und Kontaktierungsverfahren lassen sich demnach keine reproduzierbaren Kontaktwiderstände zwischen dem Metallsubstrat 110 und Silberschicht 1060 mit einem spezifischen Widerstandswert < 1 mΩ·cm² erreichen. Wird zudem der Rauschanteil der resistiven Messung mit einem Spektrum-Analysator ausgewertet, so liegt das 1/f Rauschen unbehandelter Proben um mindestens eine Größenordnung höher als bei Proben, deren Oxidschicht mit einem Laser entfernt wurde.

Zusätzliche Messungen wurden durchgeführt, um zu prüfen, ob das Entfernen der Oxidschicht 140 einen Einfluss auf die kritischen Stromdichten von HTS-Bandleitern hat. Die kritischen Stromdichten wurden mit einem berührungslosen, induktiven Verfahren an vier verschiedenen Proben vor und nach dem Entfernen der Oxidschicht 140 von der Rückseite 114 des Metallsubstrats 110 mit den angegebenen Pulsparametern gemessen. Die Mittelwerte und die Standardabweichungen der kritischen Stromdichten und die verwendeten Parametersätze sind in der Tabelle 1 zusammengefasst. Die Ergebnisse der Tabelle 1 zeigen im Rahmen der Messgenauigkeit keine nachweißbare Veränderung der kritischen Stromdichten durch das Entfernen der Oxidschicht 140 mit Hilfe des Laserstrahls 310.

Tabelle 1: Kritische Stromdichte vor und nach dem Entfernen einer Oxidschicht von der Rückseite eines Metallsubstrats für verschiedene Parametersätze des Lasers 310 beim Entfernen der Oxidschicht.

| Probe | vor der Reinigung $j_c$ [MA/cm²] | nach der Reinigung $j_c$ [MA/cm²] |
|---|---|---|
| S9 | 0,97 ± 0,15 | 0,98 ± 0,14 |
| S10 | 0,94 ± 0,16 | 0,94 ± 0,17 |
| S18 | 0,41 ± 0,13 | 0,36 ± 0,12 |
| S28 | 0,72 ± 0,15 | 0,71 ± 0,15 |

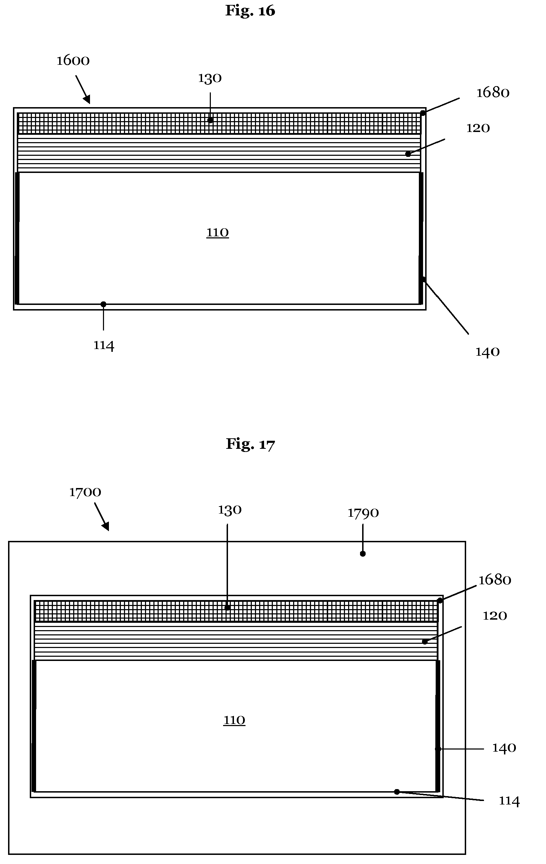

Die Fig. 16 zeigt die Basisform 100 des HTS-Bandleiters der Fig. 1 nach dem Entfernen der Oxidschicht 140 von der Rückseite 114 des Metallsubstrats 110 und dem Aufbringen einer Kontaktschicht 1680, die die HTS-Schicht 130 mit dem Metallsubstrat 110 verbindet. Wie bereits oben ausgeführt, kommen für die Kontaktschicht 1680 vorzugsweise Silber- oder Silberlegierungen (z.B. mit Gold (Au) und/oder Kupfer (Cu) Anteilen) mit einer Schichtdicke von 0,1 μm - 5 μm zum Einsatz. Auch Doppelschichten auf Ag und einem anderen Metall wie etwa Cu sind möglich. Die Dicke der Kontaktschicht 1680 liegt vorzugsweise im Bereich von 0,3 μm - 3 μm, um eine geschlossene Bedeckung auch der Kanten und eine gute Lötbarkeit des HTS-Bandleiters 1600 zu gewährleisten. Die Gesamtdicke der Beschichtungen 120, 130 und 140 oder die HTS-Schichtfolge liegt typischerweise im Bereich von 3 μm - 10 μm und ist damit gering im Vergleich zur Dicke des Metallsubstrats 110.

Das Entfernen der Oxidschicht 140 von der Rückseite 114 des Metallsubstrats mit einem Nd:YVO₄-Laser der Firma Rofin verringert die Übergangswiderstände zwischen der Kontaktschicht 1680, in dem Beispiel der Fig. 16 eine Silberschicht und dem Metallsubstrat 110, in dem Beispiel der Fig. 16 ein Hastelloy-Substrat, um etwa eine Größenordnung, von maximal 40 mΩ auf weniger als 1 mΩ. Das durchgeführte Entfernen der Oxidschicht 140 von der Rückseite 114 des Metallsubstrats hat keinen Einfluss auf die kritischen Stromdichten der HTS-Schicht 120.

Neben den Messungen zum elektrischen Übergangswiderstand wurden an den Kontaktschichten 1680 auch Haftabzugsversuche zur Bestimmung der Adhäsion der Kontaktschichten 1680 auf dem Metallsubstrat 110 durchgeführt. Abzugsversuche mit Klebeband (Scotch tape test), das flächig auf die Kontaktschicht 1680 aufgebracht und dann ruckartig von der Seite abgerissen wurde, überstand eine erfindungsgemäß hergestellte Silber-Kontaktschicht 1680, die auf eine Laser-behandelte Rückseite 114 des Metallsubstrats aufgebracht wurde, problemlos.

Ferner wurde ein Stempelabzugstest zur Quantifizierung der Adhäsion der Kontaktschicht 1680 auf dem Metallsubstrat 110 durchgeführt. Dazu wurde die Probe gemäß Fig. 16 zunächst mit der Vorderseite nach unten flächig auf eine ebene Unterlage aufgeklebt. Die Substratrückseite 114 wurde mit einer Metallmaske mit rundem Loch abgedeckt und auf die Unterlage angepresst. Innerhalb des runden Ausschnitts wurde ein runder Metallzylinder (Stempel) mit 6 mm Durchmesser zentriert und planparallel mit seiner Stirnfläche auf die auf der Rückseite 114 des Metallsubstrats 140 angebrachte Silberschicht 1480 aufgeklebt (Kleber: Zweikomponenten-Epoxidharzkleber Araldit 2011™ oder UHU 300 Plus endfest™). Der Stempel wurde mit einer hydraulischen Zugprüfmaschine senkrecht zur Substratoberfläche bis zum Abriss nach oben gezogen. Für die Haftfestigkeit der Silberschicht auf der Laser-gereinigten Substratrückseite 114 wurden damit Werte $\geq$ 4 MPa gemessen. Dabei ist zu berücksichtigen, dass bei Belastungen > 10 MPa die eingesetzten Klebstoffe versagen. Somit kann festgehalten werden, dass Kontaktschichten 1680, die auf die Rückseite 114 eines Metallsubstrats 110 aufgebracht werden, deren Oxidschicht 140 vorher mit Hilfe eines Lasers entfernt wurde, typischerweise Haftfestigkeiten > 1 MPa aufweisen.

Für viele Anwendungen muss die Konfiguration 1600 eines HTS-Bandleiters mit zusätzlichen Schichten oder Ummantelungen zur elektrischen oder mechanischen Stabilisierung verstärkt bzw. geschützt werden. Dies kann z.B. durch galvanisches Abscheiden von Kupfer oder anderen Metallen oder durch Laminieren mit weiteren Metallfolien, wie z.B. Kupfer, Messing oder Edelstahl geschehen.

Das Diagramm 1700 der Fig. 17 zeigt den HTS-Bandleiter der Fig. 15 nach dem Anbringen einer Stabilisierungsschicht 1790 aus Kupfer. Häufig ist eine Stabilisierungsschicht 1790 notwendig, um die HTS-Schicht 130 bei kurzzeitiger Überlastung zu schützen. Die Dicke dieser Stabilisierungsschicht 1790 beträgt typischerweise 10 $\mu$m - 100 $\mu$m, bevorzugt 20 $\mu$m - 50 $\mu$m, und liegt damit bereits im Bereich der Substratdicke. Nach außen hin erscheint der HTS-Bandleiter nun wie eine Metallfolie, wobei dessen Oberflächeneigenschaften dem Material der Stabilisierungsschicht 1790 entsprechen.

Zur weiteren Verarbeitung oder der Herstellung leitfähiger Verbindungen kann optional auf den stabilisierten Bandleiter zusätzlich ganz oder teilweise eine Lotschicht aufgebracht werden. Dies kann entweder durch galvanisches Abscheiden, durch eine Lötwelle oder ein Tauchbad in geschmolzenem Lot geschehen. Erfolgt der Auftrag von flüssigem Lot, so empfiehlt sich vorab die Behandlung der Oberflächen der Stabilisierungsschicht 1790 mit einem Flussmittel, das die Benetzung der Oberflächen verbessert. Um eine Degradation des HTS-Bandleiters zu verhindern, sollte die Schmelztemperatur des Lotes 250 °C nicht übersteigen. Vorzugsweise liegt sie unterhalb 200 °C.

Ein weiterer optionaler Verarbeitungsschritt ist die elektrische Isolierung das Bandleiters. Dazu kann der HTS-Bandleiter mit einer dünnen Kunststofffolie oder mit Papier umwickelt werden. Ferner ist es möglich, den Bandleiter beidseitig mit einer thermoplastischen Kunststofffolie zu laminieren, wobei Überstände an den Kanten umbördelt oder verschmolzen werden müssen. Eine weitere Methode zum Schutz eines Bandleiters ist der Auftrag einer Lackschicht. Da der HTS-Bandleiter im Betrieb auf <93 K abgekühlt wird, darf das Material der Isolierung nicht verspröden und sollte der thermischen Ausdehnung des Bandleiters angepasst sein. Gängige Materialien sind Polyimid (PI), auch unter dem Handelsnamen Kapton™ bekannt oder Polyetheretherketon (PEEK).

Zur Herstellung einer PI-Lackisolation wird vorzugsweise eine Lösung aus Polyamidocarbonsäure verwendet, die man z.B. durch Tauchen in ein Tauchbad, Sprühen oder andere gängige Methoden der Lackdrahtherstellung auf den HTS-Bandleiter aufbringt. Dabei sollte die Viskosität durch den Anteil an Lösungsmittel, wie z.B. N-Methyl-2-Pyrrolidon (NMP) oder Dimethylformamid, so eingestellt werden, dass eine vollständige Kantenbedeckung gewährleistet ist. Im Auslauf aus dem Bad kann die Lackschicht zudem durch einen Abstreifer geformt werden. Auch Lunker bzw. Bläschen können entfernt werden. Anschließend durchläuft das beschichtete Band eine heiße Zone z.B. in einem Rohrofen, in der der Lack zu Polyimid reagiert und vernetzt. Die Temperatur zur Vernetzung liegt über 250 °C, vorzugsweise zwischen 300 °C und 400 °C.

Abschließend werden noch zwei Ausführungsbeispiele angegeben.

**Beispiel 1:**

Ein einseitig elektropoliertes Substrat aus Hastelloy™ C276 mit einer Breite von 12 mm und einer Dicke von 100 $\mu$m wird unter einem Winkel von 30° gegen die Einfallsrichtung bei Raumtemperatur und $10^{-4}$ mbar Sauerstoff Restgasdruck durch Elektronenstrahlverdampfen mit einer 3 $\mu$m dicken MgO-ISD Pufferschicht beschichtet. Durch Streuung im Restgas gelangt auch eine geringe Menge an MgO auf die unpolierte Substratrückseite und bildet dort eine ca. 200 nm dicke, isolierende Schutzschicht. Auf die MgO-ISD Pufferschicht werden danach bei 720 °C eine 300 nm dicke MgO-Deckschicht und danach eine 2-3 $\mu$m dicke HTS Schicht aus $GdBa_2Cu_3O_7$ aufgebracht.

Danach wird die Substratrückseite mit dem oben beschriebenen Rofin Nd-YAG Lasersystem mit einer Pulsfrequenz von 20 kHz und einem Scangeschwindigkeit von 1000 mm/s behandelt. Daran anschließend wird der Bandleiter im Vakuum durch Verdampfen mit einer 2 $\mu$m dicken Silberschicht rundum beschichtet und anschließend in reiner Sauerstoffatmosphäre mit einer Geschwindigkeit von 20 m/h durch einen 4 m langen Rohrofen mit einem Temperaturgradienten von 600 °C bis 300 °C gezogen. Der beobachtete Übergangswiderstand zwischen der Silberschicht und dem Substrat lag unterhalb von $10^{-3}$ $\Omega \cdot cm^2$ und die Haftabzugsfestigkeit der Silberschicht betrug mehr als 1 MPa.

**Beispiel 2:**

Ein einseitig elektropoliertes Substrat aus Hastelloy™ C276 mit einer Breite von 12 mm und einer Dicke von 60 $\mu$m wurde zunächst durch das IBAD-Verfahren mit texturierenden Pufferschichten versehen und dann bei einer Temperatur von 750 °C mit einer Schicht aus $GdBa_2Cu_3O_7$ beschichtet. Durch die hohe Temperatur und den hohen Sauerstoffpartialdruck während der Beschichtung entstand auf der Substratrückseite eine ca. 200 nm dicke Zunderschicht. Die Substratrückseite wurde wie in Beispiel 1 mit dem Laser behandelt und analog zu Beispiel 1 mit Silber beschichtet und getempert. Auch in diesem Fall konnten im Vergleich zur unbehandelten Rückseite deutlich verbesserte Haftung- und Übergangswiderstände nachgewiesen werden.

**Patentansprüche**

1. Verfahren zum Herstellen eines Hochtemperatur-Supraleiters (1700) mit den folgenden Schritten:

    a. Aufbringen zumindest einer Hochtemperatur-Supraleiterschicht (130) auf zumindest eine Pufferschicht (120), die auf einer Vorderseite (112) eines metallischen Substrats (110) angeordnet ist;
    b. Teilweises Entfernen einer Isolatorschicht (140) von einer Rückseite (114) des metallischen Substrats (110) unter Verwendung eines Lasers, dessen Strahl (310) auf die Isolatorschicht (140) auf der Rückseite (114) des metallischen Substrats (110) gerichtet ist, wobei die Isolatorschicht (140) eine Oxidschicht umfasst, die sich während des Schrittes a. gebildet hat; und
    c. Aufbringen einer elektrisch leitenden Kontaktschicht (1680) auf die Rückseite (114) des metallischen Substrats (110), wobei die Kontaktschicht (1680) elektrisch mit der Hochtemperatur-Supraleiterschicht (130) verbunden ist.

2. Verfahren nach Anspruch 1, wobei der Laser ausgebildet ist, Laserpulse mit Pulsdauern kleiner 100 ns, vorzugsweise kleiner 10 ns, mehr bevorzugt kleiner 1 ns und am meisten bevorzugt kleiner 10 ps zu erzeugen.

3. Verfahren nach Anspruch 1 oder 2, wobei der Strahldurchmesser des Laserstrahls beim Auftreffen auf die Isolatorschicht (140) einen Durchmesser größer

10 $\mu$m, bevorzugt größer 50 $\mu$m aufweist.

4. Verfahren nach einem der vorhergehenden Ansprüche, wobei die Leistungsdichte des Laserstrahls beim Auftreffen auf die Isolatorschicht (140) größer als 100 MW·cm$^{-2}$, bevorzugt größer größer als 300 MW·cm$^{-2}$, und am meisten bevorzugt größer als 1 GW·cm$^{-2}$ ist.

5. Verfahren nach einem der vorhergehenden Ansprüche, wobei die Wellenlänge des Lasers im nahen ultravioletten Bereich, im sichtbaren Bereich oder im nahen infraroten Bereich zwischen 150 nm - 2000 nm, bevorzugt zwischen 200 nm - 1200 nm liegt.

6. Verfahren nach einem der vorhergehenden Ansprüche, wobei räumlich benachbarte Pulse eine laterale Überlappung ihrer Auftreffflächen auf der Isolatorschicht (140) von 0 % - 50 %, bevorzugt 0 % - 30 %, und am meisten bevorzugt 10 % - 20 % aufweisen.

7. Verfahren nach einem der vorhergehenden Ansprüche, wobei ein zeitlicher Abstand zwischen dem Auftreffen von zwei Pulsen an einer gleichen Stelle der Isolatorschicht (140) größer als 1 $\mu$s, bevorzugt größer als 50 $\mu$s, und am meisten bevorzugt größer 100 $\mu$s ist.

8. Verfahren nach einem der vorhergehenden Ansprüche, wobei ein nach dem Schritt b. auf der Rückseite (114) des metallischen Substrats (110) verbleibender Rest der Isolatorschicht (140) ein charakteristisches Punktmuster aufweist, das im Wesentlichen durch Betriebsparameter des Lasers bestimmt ist.

9. Verfahren nach einem der vorhergehenden Ansprüche, wobei nach Schritt b. die Rückseite (114) des metallischen Substrats (110) oberflächlich eine Rissstruktur aufweist.

10. Verfahren nach einem der vorhergehenden Ansprüche, wobei die auf der Rückseite (114) im Schritt c. aufgebrachte Kontaktschicht (1680) einen flächenspezifischen Übergangswiderstand zwischen dem metallischen Substrat (110) und der Kontaktschicht (1680) von weniger $10^{-3}$ $\Omega \cdot cm^2$ aufweist.

11. Hochtemperatur-Supraleiter (1700) hergestellt mit einem Verfahren nach einem der Ansprüche 1 - 10, wobei die Kontaktschicht (1680) einen flächenspezifischen Übergangswiderstand zwischen dem metallischen Substrat (110) und der Kontaktschicht (1680) von weniger $10^{-3}$ $\Omega \cdot cm^2$ aufweist.

12. Vorrichtung zum Herstellen eines Hochtemperatur-Supraleiters (1700), aufweisend:

    a. Mittel zum Aufbringen zumindest einer Hochtemperatur-Supraleiterschicht (130) auf zumindest eine Pufferschicht (120), die auf einer Vorderseite (112) eines metallischen Substrats (110) angeordnet ist;

b. Mittel zum teilweisen Entfernen einer Isolatorschicht (140) von einer Rückseite (114) des metallischen Substrats (110), wobei die Isolatorschicht (140) eine Oxidschicht umfasst, die sich während des Aufbringens der zumindest einen Hochtemperatur-Supraleiterschicht (130) gebildet hat, wobei das Mittel zum teilweisen Entfernen einen Laser umfasst, dessen Strahl (310) auf die Isolatorschicht (140) auf der Rückseite (114) des metallischen Substrats (110) gerichtet ist; und

c. Mittel zum Aufbringen einer elektrisch leitenden Kontaktschicht (1680) auf die Rückseite (114) des metallischen Substrats (110), wobei die Kontaktschicht (1680) elektrisch mit der Hochtemperatur-Supraleiterschicht (130) verbunden ist.

13. Vorrichtung nach Anspruch 12, wobei die Mittel zum teilweisen Entfernen einer Isolatorschicht (140) ein Transportsystem für einen Hochtemperatur-Supraleiter-Bandleiter (1700) umfassen.

14. Vorrichtung nach Anspruch 12 oder 13, wobei das Mittel zum teilweisen Entfernen der Isolatorschicht (140) von der Rückseite (114) des metallischen Substrats (110) ausgebildet ist, ein charakteristisches Punktmuster in einem verbleibenden Rest der Isolatorschicht (140) zu erzeugen, das im Wesentlichen durch Betriebsparameter eines Lasers bestimmt ist.

**Claims**

1. A method for manufacturing a high temperature superconductor (1700), the method comprising the following steps:

   a. applying at least one high temperature superconducting layer (130) on at least one buffer layer (120) which is arranged on a front side (112) of a metal substrate (110);
   b. partially removing an insulating layer (140) from a rear side (114) of the metal substrate (110) using a laser having a beam (310) which is directed onto the insulating layer (140) on the rear side (114) of the metal substrate (110), wherein the insulating layer (140) comprises an oxide layer which has been formed during step a.; and
   c. applying an electrically conducting contact layer (1680) on the rear side (114) of the metal substrate (110), wherein the contact layer (1680) is electrically connected to the high temperature superconductor layer (130).

2. The method of claim 1, wherein the laser is operable to generate laser pulses having pulse durations smaller than 100 ns, preferably smaller than 10 ns, more preferred smaller than 1 ns, and most preferred smaller than 10 ps.

3. The method of claim 1 or 2, wherein the beam diameter of the laser beam is larger than 10 $\mu$m, preferably larger than 50 $\mu$m when impinging on the insulating layer (140).

4. The method of any one of the preceding claims, wherein, when impinging on the insulating layer (140), the power density of the laser beam is larger than 100 MW·cm$^{-2}$, preferably larger than 300 MW·cm$^{-2}$, and most preferably larger than 1 GW·cm$^{-2}$.

5. The method of any one of the preceding claims, wherein the wavelength of the laser is in the near violet wavelength range, the visible wavelength range, or the near infrared wavelength between 150 nm - 2000 nm, preferably between 200 nm - 1200 nm.

6. The method of any one of the preceding claims, wherein spatially adjacent pulses have a lateral overlap of their impact surfaces on the insulating layer (140) of 0 % - 50 %, preferably 0 % - 30 %, and most preferred 10 % - 20 %.

7. The method of any one of the preceding claims, wherein a time distance between the impact of two pulses at the same position of the insulating layer (140) is larger than 1 $\mu$s, preferably larger than 50 $\mu$s, and most preferred larger than 100 $\mu$s.

8. The method of any one of the preceding claims, wherein a rest of the insulating layer (140) remaining at the rear side (114) of the meal substrate (110) after step b. has a characteristic dot pattern which is essentially determined by operating parameters of the laser.

9. The method of any one of the preceding claims, wherein the rear side (114) of the metal substrate (110) has a crack structure at the surface after step b.

10. The method of any one of the preceding claims, wherein the contact layer (1670) which is applied to the rear side (114) in step c. has an area-specific contact resistance between the metal substrate (110) and the contact layer (1680) of less than 10$^{-3}$ $\Omega$·cm$^2$.

11. High temperature superconductor (1700) manufactured by a method of one of claims 1 - 10, wherein the contact layer (1680) has an area-specific contact resistance between the metal substrate (110) and the contact layer (1680) of less than $10^{-3}$ $\Omega \cdot$cm$^2$.

12. An apparatus for manufacturing a high temperature superconductor (1700), comprising:

    a. means for applying at least one high temperature superconducting layer (130) on at least one buffer layer (120) which is arranged on a front side (112) of a metal substrate (110);
    b. means for partially removing an insulating layer (140) from a rear side (114) of the metal substrate (110), wherein the insulating layer (140) comprises an oxide layer which has been formed during applying the at least one superconducting layer (130), wherein the means for partially removing comprises a laser having a beam (310) which is directed onto the insulating layer (140) on the rear side (114) of the metal substrate (110); and
    c. means for applying an electrically conducting contact layer (1680) on the rear side (114) of the metal substrate (110), wherein the contact layer (1680) is electrically connected to the high temperature superconductor layer (130).

13. The apparatus of claim 12, wherein the means for partially removing an insulating layer (140) comprises a transport system for a high temperature superconductor tape (1700).

14. The apparatus of claim 12 or 13, wherein the means for partially removing the insulating layer (140) from the rear side (114) of the metal substrate (110) is operable to generate a characteristic dot pattern in a remaining rest of the insulating layer (140) which is essentially determined by operation parameters of the laser.

**Revendications**

1. Procédé de fabrication d'un supraconducteur à haute température (1700), comprenant les étapes suivantes :

    a. application d'au moins une couche supraconductrice à haute température (130) sur au moins une couche tampon (120) qui est disposée sur une face avant (112) d'un substrat métallique (110) ;
    b. élimination partielle d'une couche isolante (140) d'une face arrière (114) du substrat métallique (110) en utilisant un laser dont le faisceau (310) est dirigé sur la couche isolante (140) sur la face arrière (114) du substrat métallique (110), la couche isolante (140) comprenant une couche d'oxyde qui s'est formée pendant l'étape a. ; et
    c. application d'une couche de contact électriquement conductrice (1680) sur la face arrière (114) du substrat métallique (110), la couche de contact (1680) étant reliée électriquement à la couche supraconductrice à haute température (130).

2. Procédé selon la revendication 1, selon lequel le laser est conçu pour générer des impulsions laser avec des durées d'impulsion inférieures à 100 ns, de préférence inférieures à 10 ns, davantage de préférence inférieures à 1 ns et le plus préférentiellement inférieures à 10 ps.

3. Procédé selon la revendication 1 ou 2, selon lequel le diamètre de faisceau du faisceau laser lors de son impact sur la couche isolante (140) présente un diamètre supérieur à 10 $\mu$m, de préférence supérieur à 50 $\mu$m.

4. Procédé selon l'une des revendications précédentes, selon lequel la densité de puissance du faisceau laser lors de son impact sur la couche isolante (140) est supérieure à 100 MW$\cdot$cm$^{-2}$, de préférence supérieure à 300 MW$\cdot$cm$^{-2}$, et le plus préférentiellement supérieure à 1 GW$\cdot$cm$^{-2}$.

5. Procédé selon l'une des revendications précédentes, selon lequel la longueur d'onde du laser se situe dans le domaine de l'ultraviolet proche, dans le domaine visible ou dans le domaine de l'infrarouge proche entre 150 nm et 2000 nm, de préférence entre 200 nm et 1200 nm.

6. Procédé selon l'une des revendications précédentes, selon lequel des impulsions voisines dans l'espace présentent un chevauchement latéral de leurs surfaces d'impact sur la couche isolante (140) de 0 % à 50 %, de préférence de 0 % à 30 %, et le plus préférentiellement de 10 % à 20 %.

7. Procédé selon l'une des revendications précédentes, selon lequel un intervalle de temps entre l'impact de deux impulsions à un même emplacement de la couche isolante (140) est supérieur à 1 $\mu$s, de préférence supérieur à 50 $\mu$s, et le plus préférentiellement supérieur à 100 $\mu$s.

8. Procédé selon l'une des revendications précédentes, selon lequel un reste de la couche isolante (140) après l'étape b. sur la face arrière (114) du substrat métallique (110) présente un motif de points caractéristique qui est essentiellement déterminé par les paramètres de fonctionnement du laser.

9. Procédé selon l'une des revendications précédentes, selon lequel, après l'étape b., la face arrière (114) du substrat métallique (110) présente superficiellement une structure fissurée.

10. Procédé selon l'une des revendications précédentes, selon lequel la couche de contact (1680) appliquée sur la face arrière (114) à l'étape c. présente une résistance de contact spécifique entre le substrat métallique (110) et la couche de contact (1680) inférieure à $10^{-3}$ $\Omega \cdot cm^2$.

11. Supraconducteur à haute température (1700) fabriqué avec un procédé selon l'une des revendications 1 à 10, dans lequel la couche de contact (1680) présente une résistance de contact spécifique entre le substrat métallique (110) et la couche de contact (1680) inférieure à $10^{-3}$ $\Omega \cdot cm^2$.

12. Dispositif pour fabriquer un supraconducteur à haute température (1700), présentant:

    a. des moyens pour appliquer au moins une couche supraconductrice à haute température (130) sur au moins une couche tampon (120) qui est disposée sur une face avant (112) d'un substrat métallique (110) ;
    b. des moyens pour éliminer partiellement une couche isolante (140) d'une face arrière (114) du substrat métallique (110), la couche isolante (140) comprenant une couche d'oxyde qui s'est formée pendant l'application de ladite au moins une couche supraconductrice à haute température (130), le moyen d'élimination partielle comprenant un laser dont le faisceau (310) est dirigé sur la couche isolante (140) sur la face arrière (114) du substrat métallique (110) ; et
    c. des moyens pour appliquer une couche de contact électriquement conductrice (1680) sur la face arrière (114) du substrat métallique (110), la couche de contact (1680) étant reliée électriquement à la couche supraconductrice à haute température (130).

13. Dispositif selon la revendication 12, dans lequel les moyens d'élimination partielle d'une couche isolante (140) comprennent un système de transport pour un ruban supraconducteur à haute température (1700).

14. Dispositif selon la revendication 12 ou 13, dans lequel le moyen d'élimination partielle de la couche isolante (140) de la face arrière (114) du substrat métallique (110) est conçu pour produire un motif de points caractéristique dans un reste de la couche isolante (140), lequel motif de points est déterminé essentiellement par les paramètres de fonctionnement d'un laser.

**Fig. 1 (Stand der Technik)**

**Fig. 2 (Stand der Technik)**

**Fig. 3a**

**Fig. 3b**

**Fig. 4**

**Fig. 5a**

THEVA 2.0kV 11.0mm x20.0k SE(U) 2/7/2014          2.00um

**Fig. 5b**

THEVA 2.0kV 11.1mm x20.0k SE(U) 8/19/2014          2.00um

**Fig. 6b**

**Fig. 6b**

**Fig. 7a**

THEVA 2.0kV 11.1mm x100 LM(UL) 2/7/2014          500um

**Fig. 7b**

THEVA 2.0kV 11.1mm x100 LM(UL) 2/7/2014          500um

## Fig. 8a

810

## Fig. 8b

810

**Fig 9a**

**Fig 9b**

**Fig 9c**

920

110

THEVA 2.0kV 10.5mm x50.0k SE(U) 8/19/2014          1.00um

## Fig. 10

## Fig 11

THEVA 2.0kV 10.2mm x20.0k SE(U) 8/19/2014        2.00um

**Fig. 12**

**Fig. 13**

## Fig. 14

## Fig. 15

**Fig. 16**

1600

130

1680

120

110

114

140

**Fig. 17**

1700

130

1790

1680

120

110

140

114

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1114471 B1
- EP 1042820 B1
- DE 10225935 B4
- EP 2490273 A1
- EP 1639609 B1
- EP 0927595 B1
- US 4720621 A
- JP 2197588 A
- DE 102013210940 B3

- US 20070111893 A1
- US 5948172 A
- JP 2003205601 A
- US 20040266628 A1
- EP 0872579 A1
- EP 1178129 A1
- EP 0669411 A1
- EP 0909340 A1